(19) Europäisches Patentamt
European Patent Office
Office européen des brevets

(11) Numéro de publication : **0 060 194**
**B1**

# (12) FASCICULE DE BREVET EUROPÉEN

(45) Date de publication du fascicule du brevet : **20.02.85**

(51) Int. Cl.⁴ : **G 01 R 31/28**

(21) Numéro de dépôt : **82400377.6**

(22) Date de dépôt : **04.03.82**

## (54) Système de test de la défaillance ou du bon fonctionnement d'un circuit à composants logiques.

(30) Priorité : **11.03.81 FR 8104868**

(43) Date de publication de la demande : **15.09.82 Bulletin 82/37**

(45) Mention de la délivrance du brevet : **20.02.85 Bulletin 85/08**

(84) Etats contractants désignés : **BE DE GB IT LU NL SE**

(56) Documents cités :
**WO-A-80 /012 07**
**FR-A- 2 211 659**
**US-A- 3 881 260**
**US-A- 3 924 181**
**US-A- 3 961 250**

(73) Titulaire : **COMMISSARIAT A L'ENERGIE ATOMIQUE Etablissement de Caractère Scientifique Technique et Industriel**
**31/33, rue de la Fédération**
**F-75015 Paris (FR)**

(72) Inventeur : **Laviron, André**
**15, rue des Champs Vlaux-Daix**
**F-21121 Fontaine Les Dijon (FR)**
Inventeur : **Berard, Claude**
**27, rue de Beauregard Marcilly/Tille**
**F-21120 Is-Sur-Tille (FR)**

(74) Mandataire : **Mongrédien, André et al**
**c/o BREVATOME 25, rue de Ponthieu**
**F-75008 Paris (FR)**

EP 0 060 194 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

## Description

La présente invention concerne un système de test de la défaillance ou du bon fonctionnement d'un circuit à composants logiques dans lequel n composants forment un ensemble de composants repérés de 1 à n de manière prédéterminée. Ces composants sont reliés entre eux pour que cet ensemble présente, sur une sortie, un état logique qui dépend de l'état de défaillance ou de bon fonctionnement de l'ensemble et qui dépend de l'état de défaillance ou de bon fonctionnement de chacun des n composants de l'ensemble. Chacun des composants de l'ensemble présente au moins une entrée de simulation qui est apte à recevoir un signal de simulation de la défaillance ou du bon fonctionnement de ce composant.

Ce système de test peut permettre l'étude de circuits électroniques comprenant une pluralité de composants logiques, mais il peut permettre, par analogie, l'étude de la défaillance ou du bon fonctionnement d'un circuit hydraulique par exemple, dont un ou plusieurs composants peuvent être en état de défaillance ou de bon fonctionnement ; dans ce cas, le circuit hydraulique est remplacé par un circuit électronique comprenant une pluralité de composants logiques dont le fonctionnement est équivalent, par analogie, à celui des composants correspondants du circuit hydraulique.

Généralement, un circuit constitué de composants logiques présente une sortie dont l'état logique dépend de l'état de défaillance ou de bon fonctionnement de chacun de ses composants. Ce circuit peut être, comme on l'a mentionné plus haut, soit un circuit réel, soit un circuit simulant un circuit à étudier. Chacun des composants présente généralement une entrée qui est reliée à une sortie d'un autre composant du circuit et une autre entrée qui peut recevoir un signal de simulation de la défaillance ou du bon fonctionnement de ce composant.

Les systèmes qui permettent de tester des circuits de ce type sont généralement compliqués et coûteux, difficiles à mettre en œuvre ; ils sont généralement constitués par un calculateur qui est relié au circuit à tester par l'intermédiaire d'un interface spécifique à chaque circuit. Ce type de système nécessite un programme de traitement particulier à chaque circuit et il en résulte que les tests effectués peuvent présenter une durée importante.

Dans les tests de circuits constitués de composants logiques, l'homme de l'art a coutume d'utiliser un certain nombre de termes qui sont les suivants :

— la coupe d'un circuit est l'ensemble de tous les repères des composants défaillants de ce circuit, tels que si tous ces composants sont défaillants, le circuit est défaillant, les autres composants de ce circuit, qui ne font pas partie de la coupe, étant en bon fonctionnement ;

— le lien d'un circuit est l'ensemble de tous les repères des composants en bon fonctionnement de ce circuit, tels que si tous ces composants sont en bon fonctionnement, le circuit est en bon fonctionnement, tous les autres composants du circuit qui ne font pas partie du lien, étant défaillants.

L'ordre d'une coupe ou d'un lien est constitué par le nombre de repères des composants respectivement défaillants ou en bon fonctionnement qui décrivent la coupe ou le lien ;

— la coupe minimale est une coupe telle qu'il est impossible de trouver une autre configuration, en supprimant un ou plusieurs éléments défaillants parmi ceux dont les repères décrivent la coupe et qui permettraient de maintenir le circuit en état de défaillance ;

— un lien minimal est un lien tel qu'il est impossible de trouver une autre configuration, en supprimant un ou plusieurs composants en bon fonctionnement, parmi ceux dont les repères décrivent le lien et qui permettraient de maintenir le circuit en état de bon fonctionnement ;

— la coupe minimale par rapport à l'ordre précédent est une coupe telle qu'il n'est pas possible de trouver une autre configuration de cette coupe, en supprimant la défaillance d'un seul composant, parmi ceux dont les repères décrivent la coupe, tout en maintenant le circuit en état de défaillance ;

— de la même manière, un lien minimal par rapport à l'ordre précédent est un lien tel qu'il n'est pas possible de trouver une autre configuration de ce lien en supprimant le bon fonctionnement d'un seul composant parmi ceux dont les repères décrivent le lien, tout en maintenant le circuit en état de bon fonctionnement.

En plus des inconvénients mentionnés plus haut, les systèmes de test connus ne permettent pas, de façon simple, de déterminer si une coupe ou un lien est minimal par rapport à l'ordre précédent. Dans la suite de la description, le terme « minimal » devra être compris comme « minimal par rapport à l'ordre précédent ».

L'invention a pour but de réaliser un système de test de la défaillance ou du bon fonctionnement d'un circuit à n composants, qui permet de remédier aux inconvénients mentionnés plus haut et notamment d'effectuer des tests de manière rapide, simple, peu coûteuse et efficace, sur des circuits dont on a déterminé une coupe ou un lien ; elle permet également de rechercher de manière simple et rapide si cette coupe ou ce lien est minimal.

L'invention a pour objet un système de test de la défaillance ou du bon fonctionnement d'un circuit à composants logiques dans lequel n composants forment un ensemble de composants repérés de 1 à n de manière prédéterminée et reliés entre eux pour que cet ensemble présente sur une sortie, un état logique qui correspond à l'état de défaillance ou au bon fonctionnement de l'ensemble, et qui dépend de l'état de défaillance ou de bon fonctionnement de chacun des n composants de l'ensemble, chacun des n composants de l'ensemble présentant au moins une entrée de simulation apte à recevoir un signal de simulation de la défaillance ou du bon fonctionnement de ce composant, caractérisé en ce qu'il comprend :

— des moyens de test dont les sorties sont respectivement reliées aux entrées de simulation des composants, ces moyens de test permettant de mettre un ou plusieurs composants, respectivement en état de défaillance ou de bon fonctionnement, puis de remettre inversement et réciproquement ce ou ces composants, en état de bon fonctionnement ou de défaillance, pour une ou plusieurs combinaisons parmi les n composants de l'ensemble, ces moyens de test présentant une sortie caractéristique qui, lorsque la sortie de l'ensemble présente un état de défaillance ou de bon fonctionnement correspondant à un état de défaillance ou de bon fonctionnement des composants de l'ensemble, fournit un signal qui présente :

— un premier état logique, si la sortie de l'ensemble présente un état de bon fonctionnement ou un état de défaillance, à chaque fois qu'un ou plusieurs composants respectivement défaillant ou en bon fonctionnement sont remis par les moyens de test respectivement en bon fonctionnement ou en défaillance et ceci pour une ou plusieurs combinaisons des composants de l'ensemble, pris séparément ;

— un second état logique, si la sortie de l'ensemble présente un état de bon fonctionnement ou de défaillance, à chaque fois qu'un ou plusieurs composants respectivement en bon fonctionnement ou en défaillance sont remis par les moyens de test, respectivement en état de défaillance ou de bon fonctionnement et ceci pour une ou plusieurs combinaisons des composants de l'ensemble, puis séparément ;

— des moyens pour arrêter les moyens de test.

Selon une autre caractéristique, l'ensemble des repères des composants défaillants définissant une coupe si le circuit est défaillant et l'ensemble des repères des composants en bon fonctionnement définissant un lien si le circuit est en bon fonctionnement, l'ordre de la coupe ou du lien est défini comme étant respectivement le nombre de repères des composants défaillants ou en bon fonctionnement, les moyens de test comprennent des moyens de mémorisation comportant une bascule de mémorisation des résultats de simulation présentant une entrée de commande d'initialisation apte à recevoir un signal de commande d'initialisation pour que cette bascule présente, à l'initialisation, un état logique prédéterminé initial, correspondant respectivement à une coupe minimale ou un lien minimal si cet état est restitué à la fin du test, ces moyens de mémorisation comportant en outre un circuit logique dont une entrée est reliée à la sortie du circuit à tester et dont une sortie commande le changement d'état de la bascule, de façon à obtenir sur la sortie de celle-ci, l'état logique complémentaire de l'état prédéterminé initial dans le cas où la sortie du circuit à tester ne change pas de niveau lorqu'on simule l'état complémentaire d'un composant décrivant respectivement la coupe ou le lien étudié et ceci pour chacun des composants décrivant la coupe ou le lien, pris séparément, la bascule restant dans son état initial dans le cas où la sortie du circuit change d'état.

Selon une autre caractéristique, les moyens de test comprennent un ensemble d'au moins n bascules de mémorisation d'états logiques de simulation, les sorties de ces bascules étant reliées respectivement aux entrées de simulation des composants, les états logiques de simulation de défaillance ou de bon fonctionnement des composants du circuit étant chargés dans ces bascules à l'initialisation du système des moyens de commande dont des sorties de commande sont reliées à des entrées d'un ensemble logique de sélection et de commande des bascules, pour que la sortie de chaque bascule de mémorisation d'état de simulation, sélectionnée présente successivement et respectivement l'état logique de la bascule à l'initialisation, l'état logique inverse, puis à nouveau l'état logique de la bascule à l'initialisation.

Selon une autre caractéristique, les moyens de commande comprennent un registre à décalage comportant au moins n bascules de commande reliées en série et présentant chacune une sortie de commande, ce registre présentant en outre une entrée générale de remise à zéro, une entrée de mémorisation et une entrée de commande de décalage de ce signal, les entrées de commande de l'ensemble logique de sélection étant reliées aux sorties de commande des bascules du registre à décalage, les sorties de cet ensemble logique étant reliées à des entrées de commande des bascules de l'ensemble de mémorisation P, l'ensemble logique étant constitué de manière que chaque bascule sélectionnée pour appliquer un signal de simulation sur l'entrée de simulation de chaque composant prédéterminé, corresponde à la présence d'un niveau logique prédéterminé sur la sortie de commande de la bascule correspondante du registre à décalage, cet ensemble logique comprenant en outre deux entrées supplémentaires de commande aptes à recevoir respectivement des signaux de commande de test pour que la sortie de chaque bascule sélectionnée présente successivement l'état logique de la bascule à l'initialisation, l'état logique inverse de l'état initial, puis à nouveau l'état logique initial de cette bascule.

Selon une autre caractéristique, les moyens de commande de test comprennent en outre des moyens logiques de synchronisation pour produire sur des sorties les signaux de commande de mémorisation des résultats de simulation des signaux de remise à zéro du registre à décalage, de signaux de mémorisation et de commande de décalage appliqués aux entrées correspondantes de la première bascule du registre et un signal de commande d'initialisation appliqué à l'entrée correspondante de la bascule de mémorisation des résultats de simulation.

Selon une autre caractéristique, le système comprend en outre un compteur chargé initialement à la valeur de l'ordre de la coupe ou du lien, ce compteur présentant une entrée reliée à la sortie des moyens logiques de synchronisation qui produit les signaux de commande de mémorisation des résultats de simulation, le contenu de ce compteur décrémentant d'une unité à chaque signal de commande de mémorisation des résultats de simulation, une sortie de ce compteur étant reliée à une entrée de commande d'arrêt des moyens de synchronisation pour arrêter le système lorsque tous les composants ont été testés.

Selon une autre caractéristique, une sortie de la bascule de mémorisation des résultats de simulation est reliée d'une part à des moyens pour indiquer que la coupe ou le lien n'est pas minimal et d'autre part, à l'entrée de commande d'arrêt des moyens de synchronisation pour arrêter le système lorsque la coupe ou le lien n'est pas minimal.

Selon une autre caractéristique, l'ensemble logique de commande comprend deux ensembles de portes ET comprenant chacun un nombre de portes égal au nombre n de bascules $P_i$ et au nombre n de bascules $L_i$, chacune de ces portes correspondant à une bascule $L_i$ et à une bascule $P_i$, chaque porte ET du premier ensemble présentant une entrée reliée à une sortie de commande de la bascule correspondante du registre à décalage et une autre entrée reliée à la sortie des moyens de synchronisation pour recevoir l'un des signaux de commande de test, la sortie de cette bascule étant reliée à l'une des entrées de commande de la bascule $P_1$ de l'ensemble P pour la faire passer dans l'état inverse de son état initial, chaque porte ET du deuxième ensemble présentant une entrée reliée à une sortie de commande de la bascule $L_1$ correspondante du registre à décalage et une autre entrée reliée à la sortie des moyens de synchronisation pour recevoir un autre des signaux de commande de test, la sortie de cette porte ET étant reliée à une autre des entrées de commande de la bascule $P_1$ correspondante de l'ensemble pour ramener cette bascule dans son état initial.

Selon une autre caractéristique, l'ensemble logique de commande et de sélection comprend en outre un troisième ensemble logique de portes ET, chaque porte ET présentant une entrée reliée à la sortie de commande de la bascule $L_i$ correspondante du registre à décalage et une autre entrée reliée à la sortie de la bascule $P_i$ correspondante de l'ensemble de mémorisation, les sorties de ces portes ET étant reliées aux entrées d'une porte OU dont la sortie est reliée à une autre entrée de commande des moyens de synchronisation pour indiquer la présence d'un état logique de simulation sur une sortie d'une bascule $P_i$ sélectionnée dans l'ensemble de mémorisation.

Selon une autre caractéristique, les bascules $P_i$ de mémorisation d'états logiques de simulation sont groupées par ensembles identiques sur des modules identiques reliés en série, chacun de ces modules comprenant un registre à décalage de sorte que les registres à décalage soient reliés en série, la sortie de la dernière bascule de mémorisation d'états logiques de simulation d'un module étant reliée à l'entrée de chargement de la première bascule du module suivant, la première bascule $L_1$ du premier registre à décalage présentant les entrées de mémorisation, de remise à zéro et de commande de décalage, tandis que la sortie de commande de la dernière bascule d'un registre à décalage, est reliée à l'entrée de mémorisation du registre à décalage suivant, l'ensemble logique de commande et de sélection comprenant en outre, pour chaque module, un troisième ensemble de portes ET, chaque porte ET présentant une entrée reliée à la sortie de commande de la bascule $L_i$ correspondante du registre à décalage de ce module, et une autre entrée reliée à la sortie de la bascule $P_i$ correspondante de l'ensemble P correspondant, les sorties de ces portes ET pour chaque module étant reliées aux entrées d'une porte OU dont la sortie est reliée à une autre entrée de commande des moyens de synchronisation, par l'intermédiaire d'un transistor monté en collecteur ouvert, pour indiquer la présence d'un état logique de simulation sur une sortie d'une bascule $P_i$ sélectionnée dans un ensemble de mémorisation de l'un des modules.

D'autres caractéristiques et avantages de l'invention ressortiront mieux de la description qui va suivre, donnés en référence aux dessins annexés dans lesquels :

la figure 1A représente schématiquement un circuit hydraulique dont on veut étudier l'état de défaillance ou de bon fonctionnement en cas de défaillance ou de bon fonctionnement d'un ou de plusieurs de ses composants ;

la figure 1B représente schématiquement le circuit de la figure 1A dans lequel ont été rajoutés sur chacun des composants du circuit, des moyens permettant de simuler la défaillance ou le bon fonctionnement de chacun des composants ;

la figure 2A est un circuit logique équivalent au circuit hydraulique de la figure 1B et permettant d'étudier les coupes de ce circuit ;

la figure 2B est un circuit logique équivalent au circuit hydraulique de la figure 1B et permettant d'étudier les liens de ce circuit ;

la figure 3 représente schématiquement le système conforme à l'invention ;

la figure 4 représente schématiquement le système de l'invention, réalisé sous forme modulaire ;

la figure 5 est un schéma simplifié du système de la figure 3, pour l'étude d'une coupe à 3 composants, dans un circuit C.

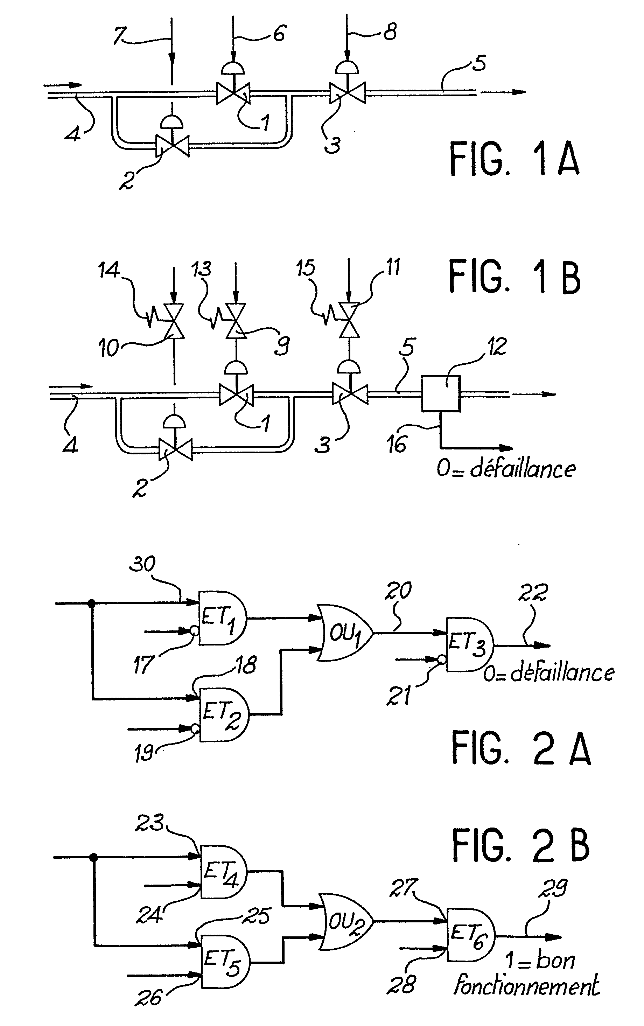

La figure 1A représente schématiquement un circuit hydraulique qui permet d'établir par exemple, la circulation entre un conduit amont 4 et un conduit aval 5, grâce à trois vannes pneumatiques, 1, 2, 3 dont l'ouverture ou la fermeture peut être commandée par la présence ou l'absence d'air comprimé dans les conduits de commande 6, 7, 8. Dans ce circuit, les vannes constituent les seuls composants qui peuvent être, soit en état de défaillance, soit en état de bon fonctionnement. Le circuit hydraulique considéré est défaillant si le fluide n'est pas transmis dans le conduit aval 5. Lorsque seules les vannes 1 et 2 sont défaillantes, le fluide ne passe plus du conduit amont 4 vers le conduit aval 5 ; il en est de même lorsque les vannes 1 et 3 sont défaillantes. Il en résulte que l'ensemble des repères 1 et 2 constitue une coupe et que de la même façon, l'ensemble des repères 1 et 3 constitue aussi une coupe. Dans ce circuit, conformément aux définitions qui ont été données plus haut, la coupe constituée par les repères 1 et 2 (portes $ET_1$, $ET_2$) est une coupe d'ordre 2 ; il en est de même pour la coupe 1,3. La coupe 1,2 est minimale car si on remet le composant 1 en bon fonctionnement, le système redevient en bon fonctionnement ; il en est de même pour le composant 2. Par contre la coupe 1,3 n'est pas minimale car si l'on remet en bon fonctionnement le composant 1, le système reste défaillant.

Lorsque seules les vannes 1 et 3 sont en bon fonctionnement, le fluide passe d'amont en aval, si bien que l'ensemble des repères 1 et 3 constitue un lien. Ce lien est d'ailleurs un lien minimal d'ordre 2 puisqu'il est impossible de trouver une autre configuration, en supprimant le bon fonctionnement d'une de ces deux vannes, qui permettent de maintenir le circuit en état de bon fonctionnement.

La figure 1B représente schématiquement le circuit de la figure précédente dans lequel ont été rajoutés, pour chacune des vannes 1, 2, 3, sur les conduits de commande 6, 7, 8, de celles-ci, des moyens 9, 10, 11 qui permettent de simuler l'état de défaillance ou de bon fonctionnement de ces vannes. Un détecteur 12 de passage fluide peut être disposé sur le conduit aval 5 pour indiquer par exemple, par un état logique 0, sur sa sortie 16, la défaillance du circuit hydraulique, lorsqu'un fluide fourni au conduit amont 4, ne se retrouve pas dans le conduit aval 5. Les moyens 9, 10, 11, qui permettent de simuler la défaillance des vannes qui leur correspondent, présentent respectivement des entrées de commande 13, 14, 15. Ces moyens sont respectivement constitués, par exemple, par une vanne à commande électrique qui intervient sur la commande pneumatique de chacune des vannes 1, 2, 3 du circuit. L'entrée de commande de chacune des vannes à commande électrique agit de manière que si une tension est appliquée sur cette entrée, cette vanne se ferme et coupe l'air comprimé qui arrive dans le conduit de commande de la vanne correspondante du circuit hydraulique. Cet arrêt d'arrivée de l'air comprimé simule la défaillance de la vanne correspondante dans le circuit. Cette défaillance étant simulée, il suffit alors d'observer le signal de sortie du détecteur de passage de fluide 12 pour savoir si cette défaillance interrompt ou non le passage du fluide vers la sortie des circuits hydrauliques.

La figure 2A représente un circuit logique équivalent au circuit hydraulique de la figure 1B ; ce circuit équivalent permet d'étudier les coupes du circuit hydraulique, c'est-à-dire sa réponse aux défaillances simulées. Dans ce circuit équivalent, la vanne 1 ainsi que la vanne 9 à commande électrique, qui permet de simuler la défaillance de la vanne 1, sont remplacées par la porte $ET_1$, une entrée directe 30 de cette porte est portée à un niveau logique 1, pour simuler l'arrivée du fluide dans le conduit amont du circuit hydraulique et une entrée inversée 17 est portée à un état logique de niveau 1, pour simuler la défaillance de ce circuit. De la même manière, la porte $ET_2$ est équivalente à la vanne 2 associée à la vanne de simulation 10, à commande électrique. Un état logique de niveau 1 sur l'entrée 18 de cette porte simule le passage du fluide, tandis qu'un état logique de niveau 1, sur l'entrée inverse 19, simule la défaillance de cette porte. Enfin, la porte $ET_3$ est équivalente à la vanne 3 et à la vanne de simulation 11, à commande électrique. L'entrée directe 20 de cette porte, portée à un état logique 1, simule le passage du fluide, tandis que l'entrée inverse 21, portée à un état logique 1, simule la défaillance de cette porte. La porte $OU_1$ est équivalente à la jonction entre les sorties des vannes 1 et 2. Ce circuit équivalent au circuit hydraulique de la figure 1B, est considéré en état de défaillance lorsque la sortie 22 de la porte $ET_3$ est à un niveau logique 0. On voit que grâce à ce circuit équivalent, il est possible d'étudier les coupes du circuit hydraulique représenté sur la figure 1B, de manière beaucoup plus simple.

Le circuit de la figure 2B est un circuit logique équivalent au circuit hydraulique de la figure 1B et il permet d'étudier les liens de ce circuit. De la même manière que précédemment, les vannes 1, 2, 3 ainsi que leurs vannes de commande de simulation 9, 10, 11, à commande électrique sont respectivement remplacées par les portes $ET_4$, $ET_5$ et $ET_6$. La porte $OU_2$ représente la jonction entre les sorties des vannes 1 et 2. Comme précédemment, les portes $ET_4$, $ET_5$ et $ET_6$ présentent des entrées 23, 25, 27 qui, lorsqu'elles sont portées à un niveau logique 1, simulent le passage du fluide dans le circuit hydraulique. Les entrées 24, 26, 28 de ces portes permettent de simuler le bon fonctionnement de chacune des vannes, lorsqu'elles sont portées à un niveau logique 1. Lorsque le circuit est en état de bon fonctionnement, la sortie 29 de la porte $ET_6$ est à un niveau logique 1. Ainsi, ce circuit logique équivalent au circuit hydraulique de la figure 1B permet d'étudier les liens de ce circuit hydraulique, c'est-à-dire son état de bon fonctionnement, en fonction de l'état de bon fonctionnement de chacun de ses composants.

Comme on le verra plus loin en détail, le système de test conforme à l'invention permet d'appliquer par exemple à chacune des entrées de simulation de défaillance ou de bon fonctionnement des portes ET des figures 2A et 2B, des signaux permettant de simuler le bon fonctionnement ou la défaillance de chacune de ces portes et de mémoriser en sortie, l'état de défaillance ou de bon fonctionnement du circuit, au cours de la simulation de chaque composant du circuit correspondant à la coupe ou au lien que l'on veut étudier.

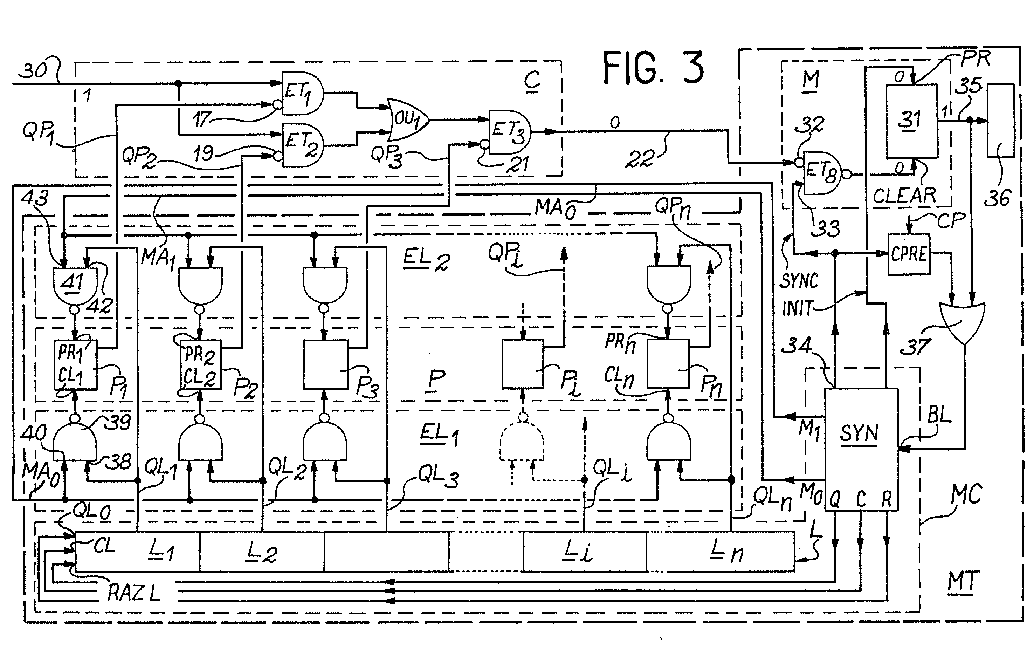

La figure 3 représente de manière schématique un système de test de la défaillance ou du bon fonctionnement d'un circuit C à n composants logiques, repérés de 1 à n, de manière prédéterminée. Le circuit C représenté en exemple sur cette figure est le même que celui de la figure 2A. Ce circuit est équivalent au circuit de la figure 1B et permet d'étudier les coupes de ce circuit. Les composants qu'il permet de simuler sont constitués par les portes $ET_1$, $ET_2$ et $ET_3$. Comme indiqué plus haut, l'entrée 30 de ce circuit est portée à un niveau logique 1 pour simuler le passage du fluide dans le circuit hydraulique correspondant. La sortie de ce circuit est représentée en 22, tandis que les entrées de simulation des différents composants sont référencées 17, 19, 21. La présence d'un niveau logique 0 sur la sortie 22 de ce circuit indique la défaillance de celui-ci.

Il est bien évident que dans l'exemple du circuit C représenté sur cette figure, le système de l'invention permet de tester une coupe sur un circuit constituée de trois composants, mais qu'il pourrait permettre de tester une coupe sur un circuit comportant un nombre n de composants, bien supérieur à 3.

Il est bien évident aussi que d'autres composants supposés non défaillants dans l'étude, peuvent être simulés dans le circuit C ; c'est par exemple le cas de la porte OU 1. Avec le circuit C, tel qu'il est décrit, plusieurs coupes peuvent être étudiées : par exemple la coupe simulant une défaillance sur les entrées 17, 19, 21, ou encore la coupe simulant une défaillance sur les entrées 17, 19, ou encore la coupe simulant une défaillance sur l'entrée 21, ou encore la coupe simulant une défaillance sur les entrées 17, 21 etc...

Enfin, le système qui va être décrit dans son application au test des composants d'une coupe dans un circuit, tel que le circuit de la figure 2A, peut être appliqué de la même manière au test des composants d'un lien dans un circuit tel que le circuit de la figure 2B.

Dans l'exemple représenté sur la figure, les sorties $QP_1$, $QP_2$, $QP_3$ des moyens de test MT sont reliées respectivement aux entrées de simulation 17, 19, 21 des portes $ET_1$, $ET_2$, $ET_3$ du circuit C. Ces moyens de test, qui seront décrits plus loin en détail, permettent d'appliquer à l'ensemble des composants, décrivant une coupe, des signaux logiques de niveau 1 simulant leur défaillance et des niveaux logiques 0 simulant le bon fonctionnement des autres composants, puis successivement à chaque composant décrivant la coupe un signal logique de niveau 0 simulant l'état de bon fonctionnement de ce composant suivi d'une remise au niveau logique 1, afin d'observer si en sortie du circuit, la remise en état de bon fonctionnement de l'un des composants maintient ou non le circuit en état de défaillance. Si à la fin de ces tests, le circuit a été remis à chaque test, en état de bon fonctionnement, c'est que la coupe étudiée est minimale. Le système de test comprend aussi des moyens de mémorisation M, reliés à la sortie 22 du circuit pour mémoriser l'état de défaillance ou de bon fonctionnement de ce circuit, au cours de la simulation des divers composants d'une coupe de celui-ci. Ces moyens de mémorisation comprennent une bascule 31 qui permet de mémoriser les résultats de simulation des divers composants de la coupe étudiée. Cette bascule bien connue dans l'état de la technique, comprend notamment des entrées de commande PR et CLEAR. L'entrée PR permet de mettre cette bascule au niveau logique 1, à l'initialisation du système, par application sur cette entrée d'un signal logique de niveau logique 0. L'entrée CLEAR permet de mettre cette bascule au niveau 0, en appliquant un signal de niveau logique 0 sur cette entrée. Comme on le verra plus loin en détail, le signal appliqué à l'entrée PR de la bascule 31, à l'initialisation du système est fourni par des moyens logiques de synchronisation SYN. L'entrée CLEAR de la bascule 31 est reliée à la sortie 22 du circuit C, par l'intermédiaire d'un circuit logique constitué par une porte $ET_8$ à sortie inversée, dont une entrée 32 inverse le niveau du signal logique provenant de la sortie 22 du circuit C. L'autre entrée 33, de la porte $ET_8$ est reliée à une sortie de moyens de test MT et plus précisément à une sortie 34 des moyens de synchronisation SYN qui permettent d'appliquer à cette porte un signal impulsionnel de synchronisation SYNC, de niveau logique 1, à chaque fois qu'un signal de simulation est appliqué à un composant. L'entrée CLEAR de la bascule 31 est une entrée de commande de mémorisation des résultats de simulation.

Si l'on procède à l'étude d'une coupe minimale la bascule 31 reste à un niveau logique 1 initial au cours de la simulation des divers composants. Comme on l'a indiqué plus haut, les 3 composants $ET_1$, $ET_2$, $ET_3$ du circuit C des figures 2A et 3, ne constituent pas une coupe minimale. Le circuit C représenté sur ces figures est équivalent au circuit hydraulique de la figure 1B ; l'arrivée du fluide à l'entrée du circuit hydraulique est simulée par un signal de niveau logique 1, appliqué à l'entrée 30 du circuit C. Si on étudie une coupe sur le circuit C, ou un circuit analogue la défaillance de ce circuit se traduit par un signal de niveau logique 0 sur la sortie 22 de celui-ci. Il en résulte qu'une coupe étudiée sur le circuit C est minimale si la sortie inversée de la porte $ET_8$ est toujours remise à un niveau logique 1 lorsque les composants qui décrivent la coupe sont remis successivement et séparément en état de bon fonctionnement, puis en état de défaillance. (C'est le cas par exemple de la coupe constituée par les composants $ET_1$, $ET_2$ du circuit C). Si la coupe est minimale, la sortie 35 de la bascule 31 reste à un niveau logique 1. Si par contre, lors de la simulation de l'un des composants du circuit C, qui traduit le bon fonctionnement de ce composant, la sortie 22 du circuit C reste à un niveau logique 0, la sortie de la porte $ET_8$ passe à un niveau 0 au moment de l'application du signal SYNC et la sortie 35 de la bascule 31, passe à un niveau logique 0 ; ce niveau logique 0 sur la sortie 35 de la bascule 31 indique qu'au cours de la simulation des différents composants, le passage d'un état de défaillance à un état de bon fonctionnement de l'un des composants a gardé le circuit C en état de défaillance et qu'ainsi, la coupe n'est pas minimale. Au cours des tests, les moyens de test MT permettent d'appliquer à l'ensemble des entrées de simulation des composants correspondant à la coupe, un niveau logique 1 simulant une défaillance, puis successivement, l'entrée de simulation de chaque composant est portée à un niveau logique 0 simulant l'état de bon fonctionnement de ce composant, puis à un niveau logique 1 simulant à nouveau un état de défaillance ; les entrées de simulation des autres composants correspondant à la coupe sont, pendant la durée de la simulation d'un composant, à un niveau logique 1 simulant la défaillance de ceux-ci.

Il est bien évident que le même agencement de signaux peut permettre d'étudier les liens sur le circuit représenté sur la figure 2B.

Le moyens de test MT comprennent un ensemble P dont au moins n bascules $P_1$, $P_2$, $P_3$, $P_i$ ... $P_n$ qui permettent de mémoriser les états logiques de simulation des composants de la coupe à étudier. Les sorties $QP_1$, $QP_2$ ... $QP_i$, ... $QP_n$ de ces bascules sont, comme on l'a mentionné plus haut, repectivement reliées aux entrées de simulation des composants des circuits C. C'est ainsi que dans l'exemple considéré, les sorties $QP_1$, $QP_2$, $QP_3$ sont respectivement reliées aux entrées de simulation 17, 19, 21 des composants du circuit C. Dans ce cas, la coupe étudiée est d'ordre 3.

Comme on le verra plus loin en détail, les états logiques de simulation de défaillance ou de bon fonctionnement des composants du circuit C qui constituent une coupe, sont chargés dans ces bascules, à l'initialisation du système. Les moyens de test MT comprennent aussi des moyens de commande MC dont des sorties $QL_1$, $QL_2$, $QL_3$ ... $QL_i$ ... $QL_n$ sont reliées à des entrées d'un ensemble logique $EL_1$, $EL_2$ de sélection et de commande des bascules $P_i$, pour que les sorties de ces bascules de mémorisation $P_i$, sélectionnées pour simuler les composants déterminés du circuit présentent tout d'abord l'état logique 1 pour simuler une défaillance dans le cas d'une coupe, puis pour que chaque sortie présente successivement l'état logique inverse (zéro), (simulant le bon fonctionnement du composant correspondant) puis à nouveau l'état logique 1 initial de la bascule.

Comme on le verra plus loin en détail, ces changements d'état logique sur les sorties des bascules $P_i$ sélectionnées, sont commandés par des signaux $MA_0$, $MA_1$, provenant des moyens de synchronisation SYN ; ces signaux sont appliqués respectivement aux ensembles logiques $EL_1$ et $EL_2$. Les moyens de commande MC comprennent un registre à décalage L ainsi que les moyens de sychronisation SYN mentionnés plus haut. Le registre à décalage L comporte au moins n bascules de commande $L_1$, $L_2$ ... $L_i$ ... $L_n$ qui sont reliées en série. Les sorties $QL_1$ ... $QL_i$ ... $QL_n$, de ces bascules constituent des sorties de commande de l'ensemble P de mémorisation d'états logiques de simulation. La première bascule $L_1$ du registre à décalage L présente trois entrées reliées respectivement aux sorties R, Q, C, des moyens de synchronisation SYN ; cette bascule reçoit ainsi un signal RAZL de remise à zéro du contenu du registre à décalage, un signal $QL_0$ présentant un état logique prédéterminé qui est mémorisé, avant décalage, dans la bascule $L_1$ du registre, et un signal CL d'horloge qui permet de commander les décalages dans le registre L du signal $QL_0$ mémorisé initialement dans la bascule $L_1$. Les entrées de commande de l'ensemble logique $EL_1$, $EL_2$ de sélection sont respectivement reliées aux sorties de commande $QL_1$ ... $QL_i$ ... $QL_n$ des bascules $L_1$ ... $L_i$ ... $L_n$. Les sorties de cet ensemble logique sont reliées à des entrées de commande $PR_1$ ... $PR_i$ ... $PR_n$, $CL_1$ ... $CL_i$ ... $CL_n$, des bascules de l'ensemble P. L'ensemble logique $EL_1$, $EL_2$ est constitué de manière que chaque bascule $P_i$ sélectionnée dans l'ensemble de mémorisation P, pour appliquer un signal de simulation sur l'entrée de simulation d'un composant prédéterminé d'une coupe du circuit C, corresponde à la présence d'un niveau logique prédéterminé (niveau 1) sur la sortie de commande $QL_i$ de la bascule $L_i$ correspondante. Cet ensemble logique présente en outre deux entrées supplémentaires de commande, aptes à recevoir respectivement les signaux $MA_0$, $MA_1$, de commande de test, pour que la sortie de chaque bascule $P_i$ sélectionnée présente successivement l'état logique de la bascule à l'initialisation (état logique 1), l'état logique inverse (état logique 0) de l'état initial, puis à nouveau l'état logique initial 1 de cette bascule. (Dans le cas de l'étude d'une coupe).

Les moyens logiques de synchronisation SYN produisent sur leurs sorties des signaux SYNC de commande de mémorisation des résultats de simulation, les signaux RAZL de remise à zéro du registre à décalage L, ainsi que les signaux $QL_0$ et CL de mémorisation et de commande de décalage, appliqués à la première bascule du registre L. Ces moyens de synchronisation produisent également sur une sortie, un signal INIT qui permet d'initialiser l'état logique de la bascule 31 de mémorisation des résultats de simulation. Dans l'exemple décrit, le signal 0, à l'initialisation du système, pour charger la bascule 31 au niveau 1.

Le système comprend aussi un compteur CPRE qui est chargé par une entrée CP, à l'initialisation, par une valeur correspondant à l'ordre de la coupe ou du lien (valeur égale à 3, si l'on considère la coupe constituée par les composants $ET_1$, $ET_2$, $ET_3$). Ce compteur présente une entrée qui est reliée à la sortie 34 des moyens de synchronisation SYN pour recevoir le signal de commande de mémorisation SYNC des résultats de simulation. Le contenu de ce compteur décroît ainsi d'une unité pour chaque signal SYNC de commande de mémorisation, reçu sur son entrée. Une sortie de ce compteur est reliée, comme on le verra plus loin en détail, à une entrée BL de commande d'arrêt des moyens de synchronisation SYN, pour arrêter le système lorsque tous les composants de la coupe ont été simulés.

Enfin, la sortie 35 de la bascule 31 de mémorisation des résultats de simulation, est reliée d'une part à des moyens 36 pour indiquer que la coupe ou le lien n'est pas minimal, et d'autre part, à l'entrée de commande d'arrêt BL des moyens de synchronisation, par l'intermédiaire d'une porte OU 37, pour arrêter le système lorsque la coupe ou le lien n'est pas minimal. Les moyens 36 peuvent être constitués par exemple par un indicateur lumineux. La coupe ou le lien n'est pas minimal lorsque la sortie 35 qui était au niveau 1, passe au niveau 0.

L'ensemble logique de sélection et de commande comprend deux ensembles $EL_1$, $EL_2$, de porte ET présentant chacune une sortie inversée. Ces deux ensembles comprennent chacun respectivement un nombre de portes égal au nombre n de bascules $P_i$ de l'ensemble P ainsi qu'au nombre n de bascules $L_i$ du registre à décalage L. Chaque porte ET à sortie inversée du premier ensemble logique $EL_1$, présente une entrée qui est reliée à une sortie de commande de la bascule $L_i$ correspondante et une autre entrée qui est reliée à la sortie $M_0$ des moyens de synchronisation pour recevoir le signal de commande de test $MA_0$.

C'est ainsi, par exemple sur la figure, que l'entrée 38 de la première porte 39 de l'ensemble $EL_1$ est reliée à la sortie $QL_1$ du registre L, tandis que l'autre entrée 40 de cette porte reçoit le signal $MA_0$ de commande de test, provenant des moyens de synchronisation SYN. Les sorties des portes de ce premier ensemble logique sont respectivement reliées, après inversion, à l'une des entrées de commande $CL_1$ ... $CL_i$ ... $CL_n$ des bascules $P_i$ de l'ensemble P. Les bascules de l'ensemble P sont chargées à l'initialisation du système. Le signal $MA_0$ de niveau logique 1 qui, après passage dans chaque porte de l'ensemble $EL_1$ devient un signal de niveau logique 0, est appliqué successivement sur les entrées de commande $CL_1$, $CL_2$, $CL_3$ des bascules de l'ensemble P et fait passer ces bascules à l'état logique 0, si leur état initial était au niveau 1.

De même manière, chaque porte ET à sortie inversée du deuxième ensemble logique $EL_2$, présente une entrée qui est reliée à une sortie de commande de la bascule $L_i$ correspondante du registre à décalage L, et une autre entrée qui est reliée à la sortie $M_1$ des moyens de synchronisation SYN, pour recevoir les signaux $MA_1$ de commande de test. Les sorties inversées de ces portes ET du deuxième ensemble logique, sont respectivement reliées aux autres entrées de commande $PR_1$ ... $PR_i$ ... $PR_n$ des bascules de l'ensemble P pour ramener ces bascules dans leur état initial (niveau logique 1) au cours des tests, grâce aux signaux $MA_1$.

C'est ainsi par exemple que la première porte ET 41 de ce deuxième ensemble logique présente une entrée 42 qui est reliée à la première sortie $QL_1$ de commande du registre à décalage L, et une autre entrée 43, qui reçoit un signal $MA_1$ de niveau logique 1 quand la bascule doit être ramenée dans son état logique initial, c'est-à-dire l'état logique 1.

Les bascules de mémorisation $P_i$ de l'ensemble de mémorisation P d'état logique de simulation peuvent être par exemple les bascules de l'ensemble P du générateur de signaux logiques combinés décrits dans la demande de brevet européen EP-A-0 058 108 au nom du même demandeur, publiée postérieurement à la date de dépôt de la présente demande.

Dans ce cas, les bascules ont été initialement chargées grâce à ce générateur de combinaison de manière qu'un agencement prédéterminé de certaines d'entre elles correspondant à la coupe ou au lien étudié, présente sur ses sorties, des signaux logiques de niveau 1.

Dans le système de test qui vient d'être décrit, des bascules successives de l'ensemble P correspondent à chacun des composants qui décrit la coupe ou le lien. Il est bien évident que d'autres bascules $P_k$ peuvent être insérées entre les bascules $P_i$ pour agir sur d'autres composants, non représentés, dont les repères ne correspondent pas à ceux de la coupe ou du lien étudié.

Il est ainsi possible d'obtenir un ensemble P de bascules, ordonnées de 1 à n, dans lequel n représente le nombre total des composants d'un circuit.

Lors des simulations des différents composants du circuit C dont on veut étudier une coupe, la sortie 22 de ce circuit est au niveau logique 0, si celui-ci est en défaillance.

Au cours des simulations des divers composants d'une coupe de circuit C, s'il apparaît que la mise en état de bon fonctionnement de l'un des composants, par l'application d'un signal de niveau logique 0 sur l'entrée de défaillance de ce composant, conserve la défaillance du circuit C, la sortie de ce circuit reste au niveau logique 0. Au moment de l'application de l'impulsion SYNC, sur la porte $ET_8$, il apparaît à la sortie de cette porte, un signal de niveau logique 0 qui provoque le passage de la bascule de mémorisation 31 à l'état logique 0. Ce changement indique alors que la coupe étudiée n'était pas une coupe minimale.

Le système fonctionne de manière différente dans la recherche d'une coupe minimale, selon que les repères de composants en panne et donc les positions des niveaux logiques 1 sur les sorties de l'ensemble de mémorisation P, sont connus ou selon que ces repères ainsi que les positions de niveaux logiques 1 sur les sorties de l'ensemble de mémorisation P, sont inconnus. A l'initialisation du système et dans les deux cas, les sorties du registre P de mémorisation de l'état logique de simulation, qui sont reliées aux entrées de simulation des composants du circuit C, sont à un niveau logique 1 pour tous les composants correspondant à la coupe et à un niveau logique 0 pour tous les autres composants. Si l'étude est celle d'une coupe, un état logique 0 est présent sur la sortie 22 de ce circuit. Si cette coupe est minimale, les simulations successives d'états de bon fonctionnement, sur chacune des entrées de simulation des trois composants de la coupe doivent toutes provoquer l'apparition d'un signal de niveau logique 1 sur la sortie 22 de ce circuit. Les composants $ET_1$, $ET_2$, $ET_3$ du circuit C ne constituent pas une coupe minimale.

En effet, la remise en état de bon fonctionnement d'un seul des composants du circuit ($ET_3$ par exemple), conserve le circuit lui-même en état de défaillance, et la coupe n'est pas minimale.

Il en résulte que le système de test de l'invention va opérer de la manière suivante, dans le cas du circuit C représenté en exemple sur la figure et dans le cas ou on étudie la coupe $ET_1$, $ET_2$, $ET_3$, d'ordre 3 : Les entrées de simulation 17, 19, 21 des portes $ET_1$, $ET_2$, $ET_3$ étant initialement à un niveau logique 1 simulant la défaillance de ces composants, l'entrée 17 de la porte $ET_1$ va être portée à un niveau logique 0, simulant l'état de bon fonctionnement de cette porte, les autres entrées de simulation des deux autres portes restant à un niveau logique 1. La simulation de l'état de bon fonctionnement de la porte $ET_1$ ne change rien sur la sortie 22 du circuit C, qui reste à l'état logique 0 et change donc sur la sortie 35 de la bascule 31 de mémorisation, qui passe à l'état logique 0, au moment de l'impulsion SYNC.

Il résulte de ces tests que la coupe constituée par les composants $ET_1$, $ET_2$, $ET_3$ du circuit C, n'est pas une coupe minimale, puisque la remise en état de bon fonctionnement de l'un des composants décrivant la coupe, ne change rien à l'état de défaillance de ce circuit. Les mêmes opérations pourraient être bien entendu effectuées sur un circuit représentant un lien, analogue par exemple à celui de la figure 2B ou sur une coupe quelconque du circuit C. C'est ainsi que la coupe d'ordre 2, constituée par les composants $ET_1$, $ET_2$, est une coupe minimale. En effet, si $ET_3$ est en bon fonctionnement, $ET_1$ et $ET_2$ en défaillance le circuit C est en défaillance ; si on simule alors le bon fonctionnement de $ET_1$, la sortie du circuit C passe en état de bon fonctionnement (niveau logique 1) ce qui ne provoque pas de changement sur la sortie 35 de la bascule 31 de mémorisation, au moment de l'impulsion SYNC. Le composant $ET_1$ est alors remis en état de défaillance. Si on simule alors le bon fonctionnement du composant $ET_2$, le circuit C passe en état de bon fonctionnement, ce qui ne provoque pas de changement sur la sortie 35 de la bascule 31. Le composant $ET_2$ est alors remis en état de défaillance. Les deux composants décrivant la coupe ayant été testés en remettant en bon fonctionnement le circuit, la coupe est donc minimale, ce qui se traduit par un niveau I à la sortie 35 de la bascule 31.

Dans le mode de réalisation du système de l'invention, représenté sur cette figure, on a supposé que les repères et donc les positions des bascules de l'ensemble P qui sont à un niveau 1, sont connus.

Dans ce cas, à l'initialisation, la bascule de mémorisation 31 est mise à 1, et le registre L est remis à zéro par un signal de remise à zéro appliqué sur l'entrée RAZL du registre L, commandant ainsi la remise à zéro de toutes les bascules $L_i$. Un signal de mémorisation de niveau logique 1 est alors appliqué sur l'entrée de mémorisation $QL_0$ du registre à décalage L, en même temps qu'une impulsion CL provoquant une mise à l'état logique 1 de la première bascule $L_1$, toutes les autres bascules du registre à décalage L étant au niveau logique 0. Cette opération est celle qui permet d'insérer un niveau logique 1 unique dans le registre L, dans la bascule $L_1$. Cette opération permet, par l'intermédiaire de la première bascule de l'ensemble logique $EL_1$ et de la première bascule de l'ensemble logique $EL_2$, de simuler le premier composant du circuit C en appliquant le signal $MA_0$. sur l'entrée 40 de la porte 39 qui fait passer la sortie $QP_1$ de la bascule $P_1$ de l'ensemble P au niveau logique 0, simulant ainsi le bon fonctionnement du premier composant $ET_1$. Si cette simulation de bon fonctionnement laisse apparaître sur la sortie 22 du circuit C, un niveau logique 0 représentant la défaillance de ce circuit, c'est que la coupe n'était pas minimale et il n'est pas nécessaire alors d'effectuer d'autres simulations.

Au contraire, si cette simulation du bon fonctionnement du composant $ET_1$ remet en état de bon fonctionnement la sortie du circuit C, une autre impulsion de décalage est appliquée à l'entrée CL du registre à décalage L, tandis que l'entrée $QL_0$ est portée au niveau logique 0. Cette nouvelle impulsion appliquée à l'entrée CL du registre à décalage propage le niveau 1 qui était contenu dans la bascule $L_1$, dans la bascule $L_2$ pour permettre la simulation du composant $ET_2$ par l'intermédiaire de la bascule $P_2$.

Il est bien évident que ce niveau est propagé jusqu'à la bascule $L_i$ du registre à décalage L, pour permettre la simulation du composant de rang i, par l'intermédiaire de la bascule $P_i$.

Il est bien évident que si les composants de rang i décrivant la coupe ne correspondent pas à des bascules $P_i$ successives, il faut propager le niveau 1 dans le registre L en face de chacune des bascules P correspondant aux composants décrivant la coupe.

Bien entendu aussi, après la simulation de bon fonctionnement du composant $ET_1$, la bascule $P_1$ de l'ensemble P est remise à l'état initial de niveau 1 grâce à l'application du signal $MA_1$ sur la première porte de l'ensemble logique $EL_2$, la bascule $P_1$ ayant été mise à 0 par application du signal $MA_0$ sur la première porte de l'ensemble logique $EL_1$. L'application des signaux $MA_0$ et $MA_1$ est répétée un nombre de fois égal à celui des composants qui constituent la coupe. Si à la fin de toutes ces opérations, la bascule de mémorisation 31 est restée à l'état logique 1, c'est que la coupe était minimale, comme on l'a indiqué plus haut.

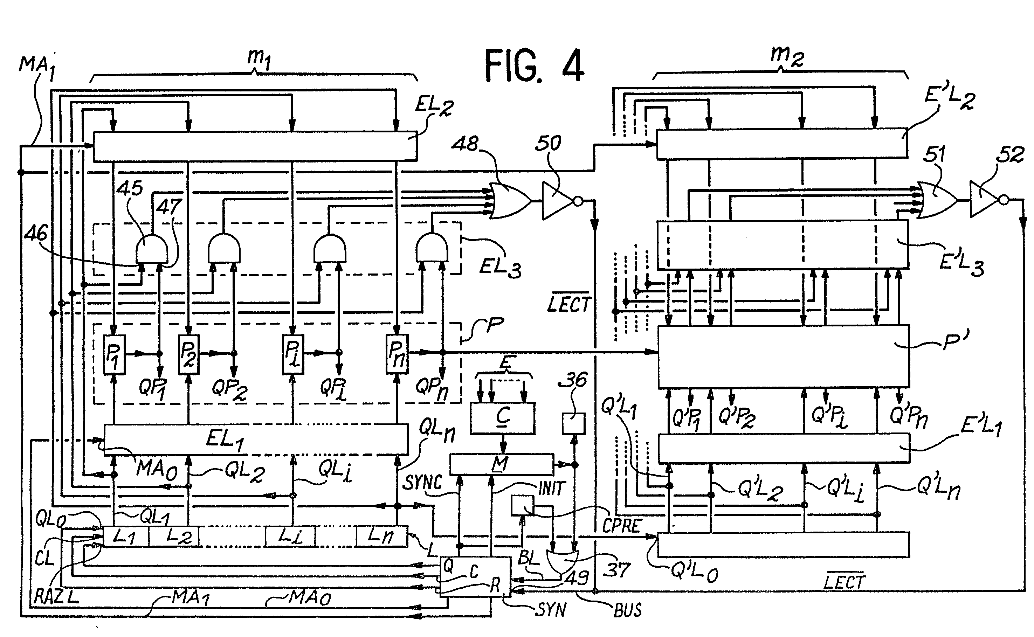

La figure 4 représente schématiquement deux autres modes de réalisation d'un système conforme à l'invention. L'un de ces modes de réalisation concerne le cas où la position des bascules de l'ensemble de mémorisation P, qui sont à un niveau logique 1, est inconnue. Un autre mode de réalisation, qui est représenté sur la même figure, concerne le cas où la position des bascules de l'ensemble P, qui sont au niveau 1, étant inconnue, le système est construit sous forme modulaire. Les mêmes éléments portent les mêmes références sur cette figure et sur la figure précédente.

Dans le mode de réalisation qui est représenté sur la partie gauche de la figure, le système de l'invention comprend comme précédemment, les bascules $P_1$, $P_2$ ... $P_n$ de l'ensemble de mémorisation P qui délivrent sur leurs sorties les signaux $QP_1$, $QP_2$ ... $QP_i$ ... $QP_n$. Il comprend également l'ensemble logique $EL_1$ et $EL_2$ qui reçoit les signaux $MA_0$ et $MA_1$ qui permettent de commander les changements d'états logiques des sorties prédéterminées des bascules de l'ensemble P ; il comprend également le registre à décalage L, formé des bascules $L_1$, $L_2$ ... $L_i$ ... $L_n$ qui reçoit respectivement sur ses entrées, un signal de mémorisation $QL_0$, des signaux de commande de décalage CL, et un signal de remise à zéro RAZL.

On a aussi représenté sur cette figure les moyens de synchronisation SYN qui commandent le registre à décalage L, qui fournissent les signaux $MA_0$ et $MA_1$ ainsi que les signaux SYNC et INIT qui commandant le compteur CPRE. On a aussi représenté les moyens de mémorisation M des résultats de simulation du circuit C ; ce circuit reçoit sur ses entrées E les signaux de sorties prédéterminées provenant des bascules de l'ensemble P. La porte OU 37, reliée au compteur CPRE ainsi qu'à la sortie des moyens de mémorisation des résultats de simulation M, fournit, comme on l'a mentionné plus haut, le signal de blocage BL des moyens de synchronisation SYN.

Enfin, les moyens indiquant que la coupe ou le lien n'est pas minimal, sont représentés en 36.

Dans ce mode de réalisation, le système fonctionne de la même manière que précédemment, sauf en ce qui concerne la sélection des bascules de l'ensemble P de mémorisation ; cette sélection permet de simuler le circuit C, sur ses entrées E. En effet, si les bascules $P_i$ correspondant aux composants décrivant la coupe sont à un niveau 1 permettant de simuler les entrées du circuit C, et sont mélangées à des bascules $P_k$ à un niveau 0, et si la position des bascules $P_i$ de l'ensemble P, est inconnue, il est nécessaire de gérer ce registre à décalage L d'une manière différente de celle qui a été décrite plus haut.

Dans ce cas, l'ensemble logique de commande comprend en outre un troisième ensemble logique $EL_3$ de porte ET ; chacune de ces portes présente une entrée qui est reliée à la sortie de commande de la bascule $L_i$ correspondante dans le registre à décalage L, et une autre entrée qui est reliée à la sortie de la bascule $P_i$ correspondante, dans l'ensemble de mémorisation P. C'est ainsi par exemple que la porte ET 45, de l'ensemble logique $EL_3$ présente une entrée 46 qui est reliée à la sortie $QL_1$ de la bascule $L_1$ du registre à décalage L, et une entrée 47 qui est reliée à la sortie $QP_1$ de la bascule $P_1$ de l'ensemble P. Les sorties des portes de l'ensemble logique $EL_3$ sont reliées aux entrées d'une porte OU 48, dont la sortie est reliée à une entrée 49 des moyens de synchronisation SYN, par l'intermédiaire d'un amplificateur inverseur 50. La sortie de cet amplificateur applique à l'entrée 49 des moyens de synchronisation SYN, dans des conditions que l'on définira par la suite, un signal $\overline{LECT}$.

Dans ce mode de réalisation, le système fonctionne de la manière suivante : on propage toujours un niveau logique 1 unique dans le registre L. Pour rechercher par exemple, si l'état logique de la bascule $P_m$ de rang m compris entre 1 et n, est 1, on propage dans le registre L un niveau logique 1 jusqu'à la bascule $L_m$. La porte ET correspondante de l'ensemble logique $EL_3$, dont les entrées sont reliées respectivement à la sortie $QP_m$ de la bascule $P_m$ et à la sortie $QL_m$ de la bascule $L_m$ du registre à décalage L, valide la transmission du niveau logique 1 de sortie de la bascule $P_m$, vers le circuit SYN, grâce à un signal $\overline{LECT}$ apparaissant alors sur la sortie de l'amplificateur-inverseur 50 qui est reliée à l'entrée 49 des moyens de synchronisation SYN. Ces moyens de synchronisation déclenchent sur la réception du signal $\overline{LECT}$ la validation du signal $MA_0$ puis celle du signal $MA_1$, ces signaux sont appliqués successivement sur les portes ET à sortie inversée, qui correspondent à la bascule $P_m$, dans l'ensemble logique $EL_1$ et $EL_2$.

Initialement, les bascules $P_i$ dont les sorties correspondent à la coupe ou au lien à étudier, sont portées au niveau logique 1, par exemple à l'aide du générateur de signaux logiques combinés, décrit dans la demande de brevet précitée. La bascule des moyens M de mémorisation des résultats de simulation est chargée par un niveau logique 1, tandis que le compteur CPRE est chargé avec l'ordre de la coupe, c'est-à-dire 3, dans l'exemple de coupe d'ordre 3 décrit plus haut, comprenant les portes $ET_1$, $ET_2$, $ET_3$. Un niveau logique 1 est alors injecté sur l'entrée $QL_0$ de la bascule $L_1$ après que le registre à décalage L ait été remis à zéro par un signal de remise à zéro appliqué sur son entrée RAZL. Si le signal $\overline{LECT}$ est au niveau logique 0, c'est que la bascule $P_1$ correspondant à la bascule $L_1$ du registre à décalage, présente sur sa sortie $QP_1$ un niveau logique 1.

Dans le cas contraire, des impulsions CL sont appliquées sur l'entrée de commande de décalage, du registre à décalage L ; chacune de ces impulsions est suivie d'un test du signal $\overline{LECT}$. Si à la suite d'un test, ce signal est au niveau 1, une nouvelle impulsion est envoyée sur l'entrée CL du registre à décalage, jusqu'à ce que le signal $\overline{LECT}$ soit au niveau logique 0, indiquant ainsi la présence d'un niveau logique 1 sur une sortie d'une bascule de l'ensemble de mémorisation P qui correspond à la bascule qui est au niveau 1 dans le registre L. A chaque fois qu'un niveau logique 1 est trouvé sur une sortie $QP_i$ de l'ensemble de mémorisation P, les signaux $MA_0$ et $MA_1$ sont appliqués successivement sur les entrées des ensembles logiques $EL_1$ et $EL_2$. Toutes ces opérations sont répétées jusqu'à ce que le compteur CPRE, qui a été chargé initialement à la valeur de l'ordre de la coupe soit à zéro.

En effet, lorsque ce compteur est à zéro, c'est que tous les composants de la coupe ou du lien ont été simulés. La coupe est alors minimale si la bascule de mémorisation de l'ensemble M est restée à l'état logique 1. Les mêmes opérations seraient effectuées dans le cas d'un lien tel que celui qui est représenté en exemple sur la figure 2B.

Sur la figure 4, on a aussi représenté un autre mode de réalisation du système de l'invention ; dans ce mode de réalisation, le système fonctionne de la même manière. Le système est ici réalisé sous forme modulaire et on n'a représenté sur cette figure que deux modules $m_1$ et $m_2$, mais il est évident qu'il serait possible d'associer un nombre plus important de modules. Les bascules de mémorisation $P_i$ sont groupées en ensembles identiques P, P' ... reliés en série, de sorte que la dernière bascule $P_n$ du premier module $m_1$ soit reliée à l'entrée de la première bascule de l'ensemble P' du deuxième module $m_2$. Les modules comprennent des registres à décalage L, L' ... identiques. Le registre à décalage du premier module $m_1$ comprend notamment les entrées de mémorisation, de remise à zéro, et de commande de décalage $QL_0$, RAZL et CL, tandis que la sortie de commande $QL_n$ de la dernière bascule du registre à décalage L du premier module $m_1$, est reliée à l'entrée de mémorisation $Q'L_0$ du registre à décalage L' du module suivant. Les modules $m_1$ et $m_2$ comprennent respectivement les premier, deuxième et troisième ensembles logiques $EL_1$, des bascules de l'ensemble de mémorisation P' du second module $m_2$ sont représentées en $Q'P_1$, $Q'P_2$ ... $Q'P_i$ ... $Q'P_n$. Les sorties de commande du registre à décalage L' de ce second module, sont représentées en $Q'L_1$ ... $Q'L_i$ ... $Q'L_n$ ; elles sont reliées aux entrées des ensembles logiques $E'L_1$, $E'L_2$, $E'L_3$. Les sorties du troisième ensemble logique $E'L_3$ du deuxième module $m_2$ sont reliées aux entrées d'une porte OU 51, dont la sortie est reliée à l'entrée de commande 49 des moyens de synchronisation SYN par l'intermédiaire de l'amplificateur-inverseur 52, comparable à l'amplificateur-inverseur 50 et par l'intermédiaire de la ligne BUS.

Comme précédemment aussi, la sortie de l'amplificateur 52 fournit un signal $\overline{LECT}$ à chaque fois qu'un niveau 1 est trouvé sur une sortie $Q'P_i$ d'une bascule $P'_i$ de l'ensemble P', grâce à la présence d'un niveau 1 sur la sortie correspondante $Q'L_i$ d'une bascule $L'_i$ du registre à décalage L'.

En fait, cette construction modulaire permet de disposer d'un nombre important de signaux de simulation, lorsqu'une coupe C comportant un très grand nombre de composants, est à étudier. Chacun des amplificateurs 50 et 52 est constitué par un transistor monté en collecteur ouvert (connu dans l'état de la technique et décrit dans la demande de brevet précitée).

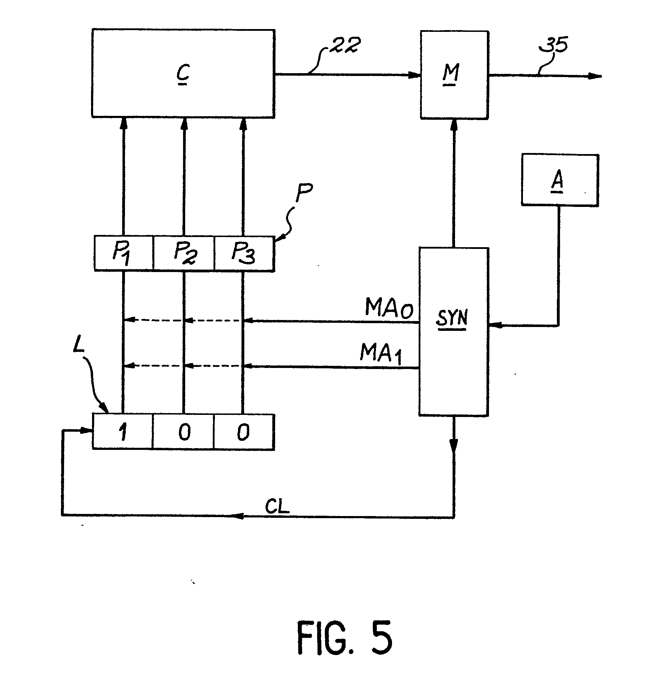

La figure 5 représente schématiquement, de manière simplifiée, le système de test de la figure 3. Sur cette figure, on a représenté le circuit C pour lequel on veut étudier une coupe constituée de trois composants. Les entrées de simulation de ces composants sont reliées respectivement aux sorties des bascules $P_1$, $P_2$, $P_3$ de l'ensemble de mémorisation P. Toutes ces bascules sont mises au niveau logique 1, pour simuler une panne des trois composants simultanément. Comme il s'agit d'une coupe, la sortie 22 du circuit C est dans un état logique indiquant la défaillance, c'est-à-dire dans l'état logique 0, comme indiqué plus haut (figure 3).

Pour savoir si cette coupe est minimale par rapport à l'ordre précédent, le système fonctionne de la manière suivante :

Le registre à décalage L est chargé par un seul niveau logique 1, en première position, par les moyens de synchronisation SYN. La sortie 35 des moyens de mémorisation M est initialisée au niveau logique 1. Les moyens de synchronisation SYN, grâce au signal $MA_0$, mettent à zéro la bascule $P_1$ qui est située en face de la première bascule du registre L qui est à un niveau logique 1. Si la sortie 22 du circuit C passe à un niveau logique qui indique le bon fonctionnement de ce circuit, c'est-à-dire au niveau logique 1, la sortie 35 des moyens de mémorisation M reste au niveau logique 1. Dans le cas contraire, la sortie 35 des moyens de mémorisation M passe au niveau logique 0 et le teste peut être arrêté par les moyens d'arrêt A, car la coupe n'est pas minimale. Les moyens A qui ne sont pas décrits ici en détail, comprennent notamment le compteur CPRE et la porte OU 37 (figure 3). Si le test n'est pas terminé, les moyens se synchronisation SYN remettent au niveau logique 1 la bascule $P_1$, par le signal $MA_1$. Le même processus est alors répété en décalant le niveau logique 1 dans le registre L et le même test est effectué à partir de la bascule de mémorisation $P_2$, puis de la même manière, à partir de la bascule de mémorisation $P_3$.

Lorsque tous les composants décrivant la coupe sont testés, sans arrêt par passage au niveau logique 0 de la sortie 35 des moyens de mémorisation M, les moyens d'arrêt A arrêtent le test. La sortie 35 des moyens de mémorisation M présente alors un niveau logique 1 qui indique que la coupe est minimale. Le fonctionnement qui vient d'être décrit peut être repris de la même manière, en remplaçant le mot « coupe » par le mot « lien » et le mot « défaillance » par le mot « bon fonctionnement ».

Si l'on veut étudier sur le même circuit C, une coupe ne comprenant que deux composants (les composants 1 et 3 par exemple), il y a deux solutions : il est possible de relier la sortie de la bascule $P_1$ au composant 1 et la sortie de la bascule $P_2$ au composant 3, puis d'opérer de la manière décrite plus haut.

Il est également possible de laisser les entrées de simulation des composants 1, 2, 3 reliées respectivement aux sorties des bascules $P_1$, $P_2$, $P_3$, et de maintenir la sortie de la bascule $P_2$ au niveau logique 0, en permanence, pour simuler le bon fonctionnement du composant 2. Lors du fonctionnement du système, au lieu de procéder à un seul décalage du niveau 1 dans le registre L, on réalise des décalages jusqu'à la bascule $P_i$ de rang i correspondant aux composants suivants décrits par la coupe. Dans l'exemple considéré, le niveau 1 contenu dans le registre L serait positionné successivement en regard des bascules $P_1$, puis $P_3$.

**Revendications**

1. Système de test de la défaillance ou de bon fonctionnement d'un circuit (C) à composants logiques, dans lequel n composants forment un ensemble de composants repérés de 1 à n de manière prédéterminée et reliés entre eux pour que cet ensemble présente sur une sortie, un état logique qui correspond à l'état de défaillance ou au bon fonctionnement de l'ensemble, et qui dépend de l'état de défaillance ou de bon fonctionnement de chacun des n composants de l'ensemble, chacun des n composants de l'ensemble présentant au moins une entrée de simulation apte à recevoir un signal de simulation de la défaillance ou du bon fonctionnement de ce composant, caractérisé en ce qu'il comprend :

— des moyens de test (MT) dont les sorties sont respectivement reliées aux entrées de simulation des composants, ces moyens de test permettant de mettre un ou plusieurs composants, respectivement en état de défaillance ou de bon fonctionnement, puis de remettre inversement et réciproquement ce ou ces composants, en état de bon fonctionnement ou de défaillance, pour une ou plusieurs combinaisons parmi les n composants de l'ensemble, ces moyens de test présentant une sortie (35) caractéristique qui, lorsque la sortie de l'ensemble présente un état de défaillance ou de bon fonctionnement correspondant à un état de défaillance ou de bon fonctionnement des composants de l'ensemble, fournit un signal qui présente :

— un premier état logique, si la sortie de l'ensemble présente un état de bon fonctionnement ou un état de défaillance, à chaque fois qu'un ou plusieurs composants respectivement défaillant ou en bon fonctionnement sont remis par les moyens de test respectivement en bon fonctionnement ou en défaillance et ceci pour une ou plusieurs combinaisons des composants de l'ensemble pris séparément ;

— un second état logique, si la sortie de l'ensemble présente un état de défaillance ou de bon fonctionnement à chaque fois qu'un ou plusieurs composants respectivement en défaillance ou en bon fonctionnement sont remis par les moyens de test, respectivement en état de bon fonctionnement ou de défaillance et ceci pour une ou plusieurs combinaisons des composants de l'ensemble, pris séparément ;

— des moyens (CPRE, BL) pour arrêter les moyens de test.

2. Système de test, selon la revendication 1, caractérisé en ce que l'ensemble des repères des composants défaillants définissant une coupe si le circuit est défaillant et l'ensemble des repères des composants en bon fonctionnement définissant un lien si le circuit est en bon fonctionnement, l'ordre de la coupe ou du lien est défini comme étant respectivement le nombre de repères des composants défaillants ou en bon fonctionnement, les moyens de test (MT) comprennent des moyens de mémorisation (M) comportant une bascule (31) de mémorisation des résultats de simulation présentant une entrée (PR) de commande d'initialisation apte à recevoir un signal de commande d'initialisation pour que cette bascule (31) présente, à l'initialisation, ledit premier état logique prédéterminé initial, correspondant respectivement à une coupe minimale ou un lien minimal si cet état est restitué à la fin du test, ces moyens de mémorisation comportant en outre un circuit logique ($ET_8$) dont une entrée est reliée à la sortie du circuit (C) à tester et dont une sortie commande le changement d'état de la bascule, de façon à obtenir sur la sortie (35) de celle-ci, ledit second état logique complémentaire dudit premier état logique initial, dans le cas où la sortie du circuit (C) à tester ne change pas de niveau lorsqu'on simule l'état complémentaire d'un composant décrivant respectivement la coupe ou le lien étudié et ceci pour chacun des composants décrivant la coupe ou le lien, pris séparément, la bascule restant dans son état initial dans le cas où la sortie du circuit (C) change d'état.

3. Système selon la revendication 2, caractérisé en ce que les moyens de test (MT) comprennent en outre un ensemble d'au moins n bascules ($P_1$, $P_2$ ... $P_i$ ... $P_n$) de mémorisation d'états logiques de simulation, les sorties ($QP_1$, $QP_2$ ... $QP_i$ ... $QP_n$) de ces bascules étant reliées respectivement aux entrées de simulation (17 ou 19 ou 21 ...) des composants décrivant la coupe ou le lien, les états logiques de simulation de défaillance ou de bon fonctionnement des composants du circuit (C) étant chargés dans ces bascules ($P_1$, $P_2$ ... $P_i$ ... $P_n$) à l'initialisation du système des moyens de commande (MC) dont des sorties de commande ($QL_1$, $QL_2$ ... $QL_i$ ... $QL_n$, $M_1$, $M_2$, Q, C, R) sont reliées à des entrées d'un ensemble logique ($EL_1$, $EL_2$) de sélection et de commande des bascules ($P_i$) pour que la sortie ($QP_i$) de chaque bascule ($P_i$) de mémorisation d'état de simulation, sélectionnée présente successivement et respectivement l'état logique de la bascule à l'initialisation, l'état logique inverse, puis à nouveau l'état logique de la bascule à l'initialisation.

4. Système selon la revendication 3, caractérisé en ce que les moyens de commande (MC) comprennent un registre à décalage (L) comportant au moins n bascules de commande ($L_1$, $L_2$ ... $L_i$ ... $L_n$) reliées en série et présentant chacune une sortie de commande ($QL_i$), ce registre présentant en outre une entrée générale de remise à zéro (RAZL), une entrée de mémorisation d'un signal ($QL_0$) présentant un état logique prédéterminé et une entrée (CL) de commande de décalage de ce signal, les entrées de commande de l'ensemble logique de sélection ($EL_1$, $EL_2$) étant reliées aux sorties de commande ($QL_1$ ... $QL_i$ ... $QL_n$) des bascules ($L_1$ ... $L_i$ ... $L_n$) du registre à décalage, (L) les sorties de cet ensemble logique étant reliées à des entrées de commande ($PR_1$ ... $PR_i$ ... $PR_n$, $CL_1$ ... $CL_i$ ... $CL_n$) des bascules ($P_i$) de l'ensemble (P), l'ensemble logique ($EL_1$, $EL_n$) étant constitué de manière que chaque bascule ($P_i$) sélectionnée pour appliquer un signal de simulation sur l'entrée de simulation de chaque composant prédéterminé, corresponde à la présence d'un niveau logique prédéterminé sur la sortie de commande ($QL_i$) de la bascule ($L_i$) correspondante, cet ensemble logique comprenant en outre deux entrées supplémentaires de commande aptes à recevoir respectivement des signaux ($MA_0$, $MA_1$) de commande de test, pour que la sortie de chaque bascule ($P_i$) sélectionnée présente successivement l'état logique de la bascule à l'initialisation, l'état logique inverse de l'état initial, puis à nouveau l'état logique initial de cette bascule.

5. Système selon la revendication 4, caractérisé en ce que les moyens de commande (MC) comprennent en outre des moyens logiques (SYN) de synchronisation pour produire sur des sorties les signaux (SYNC) de commande de mémorisation des résultats de simulation, des signaux (RAZL, $QL_0$, CL) de remise à zéro du registre à décalage (L), de mémorisation et de commande de décalage (L), appliqués aux entrées correspondantes de la première bascule du registre (L) et un signal (INIT) de commande d'initialisation, appliqué à l'entrée correspondante de la bascule de mémorisation (31) des résultats de simulation.

6. Système selon la revendication 5, caractérisé en ce qu'il comprend en outre un compteur (CPRE) chargé initialement à la valeur de l'ordre de la coupe ou du lien, ce compteur présentant une entrée (CP) reliée à la sortie (34) des moyens logiques de synchronisation qui produit les signaux de commande (SYNC) de mémorisation des résultats de simulation, le contenu de ce compteur décrémentant d'une unité à chaque signal de commande de mémorisation des résultats de simulation, une sortie de ce compteur étant reliée à une entrée (BL) de commande d'arrêt des moyens de synchronisation (SYN) pour arrêter le système lorsque tous les composants ont été testés.

7. Système selon la revendication 6, caractérisé en ce qu'une sortie (35) de la bascule de mémorisation (31) des résultats de simulation est reliée d'une part à des moyens (36) pour indiquer que la coupe ou le lien n'est pas minimal et d'autre part, à l'entrée de commande d'arrêt (BL) des moyens de synchronisation (SYN) pour arrêter le système lorsque la coupe ou le lien n'est pas minimal.

8. Système selon la revendication 5, caractérisé en ce que l'ensemble logique de sélection et de commande comprend deux ensembles ($EL_1$, $EL_2$) de portes ET comprenant chacun un nombre de portes égal au nombre n de bascules ($P_i$) et au nombre n de bascules ($L_i$), chacune de ces portes correspondant à une bascule ($L_i$) et à une bascule ($P_i$), chaque porte ET (39) du premier ensemble ($EL_1$) présentant une entrée (38) reliée à une sortie ($QL_1$) de commande de la bascule ($L_1$) correspondante du registre (L) à décalage et une autre entrée (40) reliée à la sortie ($M_0$) des moyens de synchronisation pour recevoir l'un des signaux ($MA_0$) de commande de test, la sortie de cette bascule étant reliée à l'une des entrées ($CL_1$) de commande de la bascule ($P_1$) de l'ensemble (P) pour la faire passer dans l'état inverse de son état initial, chaque porte ET (41) du deuxième ensemble ($EL_2$) présentant une entrée (42) reliée à une sortie ($QL_1$) de commande de la bascule ($L_1$) correspondante du registre à décalage (L) et une autre entrée (43) reliée à la sortie ($M_1$) des moyens de synchronisation (SYN) pour recevoir un autre ($MA_1$) des signaux de commande de test, la sortie de cette porte ET étant reliée à une autre des entrées ($PR_1$) de commande de la bascule ($P_1$) correspondante de l'ensemble (P) pour ramener cette bascule dans son état initial.

9. Système selon la revendication 8, caractérisé en ce que l'ensemble logique de commande et de sélection comprend en outre un troisième ensemble logique ($EL_3$) de portes ET, chaque porte ET présentant une entrée reliée à la sortie de commande ($QL_i$) de la bascule ($L_i$) correspondante du registre à décalage (L) et une autre entrée reliée à la sortie de la bascule ($P_i$) correspondante de l'ensemble de mémorisation (P), les sorties de ces portes ET étant reliées aux entrées d'une porte OU (48) dont la sortie est reliée à une autre entrée de commande (49) des moyens de synchronisation (SYN) pour indiquer la présence d'un état logique de simulation sur une sortie d'une bascule ($P_i$) sélectionnée dans l'ensemble de mémorisation (P).

10. Système selon la revendication 8, caractérisé en ce que les bascules ($P_i$) de mémorisation d'états logiques de simulation sont groupées par ensembles (P, P' ...) identiques sur des modules identiques ($m_1$, $m_2$) reliés en série, chacun de ces modules comprenant un registre à décalage (L, L' ...) de sorte que les registres à décalage soient reliés en série, la sortie de la dernière bascule de mémorisation d'états logiques de simulation d'un module ($m_1$) étant reliée à l'entrée de chargement de la première bascule du module ($m_2$) suivant, la première bascule ($L_1$) du premier registre à décalage présentant les entrées de mémorisation, de remise à zéro et de commande de décalage ($QL_0$, RAZL, CL), tandis que la sortie de commande de la dernière bascule d'un registre à décalage, est reliée à l'entrée de mémorisation du registre à décalage suivant, l'ensemble logique de commande et de sélection comprenant en outre, pour chaque module, un troisième ensemble de portes ET ($EL_3$, $E'L_3$), chaque porte ET présentant une entrée reliée à la sortie de commande de la bascule ($L_i$) correspondante du registre à décalage de ce module, et une autre entrée reliée à la sortie de la bascule ($P_i$) correspondante de l'ensemble (P) correspondant, les sorties de ces portes ET pour chaque module étant reliées aux entrées d'une porte OU (48, 51) dont la sortie est reliée à une autre entrée de commande (49) par des moyens de synchronisation (SYN), par l'intermédiaire d'un transistor monté en collecteur ouvert, pour indiquer la présence d'un état logique de simulation sur une sortie d'une bascule ($P_i$) sélectionnée dans un ensemble de mémorisation (P ou P') de l'un des modules ($m_1$, $m_2$).

**Claims**

1. System for testing the failure or satisfactory operation of a circuit (C) of logic components in which n components form an assembly of components referenced from 1 to n in predetermined fashion and connected to one another so that this assembly presents at an output a logic state which corresponds to the state of failure or to satisfactory operation of the assembly, and which depends on the state of failure or satisfactory operation of each of n components of the assembly, each of the n components of the assembly having at least one simulation input adapted to receive a signal simulating the failure or satisfactory operation of the said component, characterised in that it comprises:

— test means (MT) of which the outputs are respectively linked to the simulation inputs of the components, the said test means making it possible to put one or a plurality of components respectively into a condition of failure or of satisfactory operation, then of inversely and reciprocally restoring this or theses components to a state of satisfactory operation or of failure or one or a plurality of combinations among the n components of the assembly, the said test means having a characteristic output (35) which, when the output of the assembly is in a condition of failure or of satisfactory operation corresponding to a state of failure or of satisfactory operation of the components of the assembly, supplies a signal which exhibits;

— a first logic state if the output of the assembly shows a state of satisfactory operation or a state of failure, whenever one or a plurality of components respectively defective or satisfactorily functioning are restored by the test means respectively to a state of satisfactory operation or failure, this for one or a plurality of combinations of components of the assembly considered separately;

— a second logic state if the output of the assembly shows a condition of failure or a condition of satisfactory operation whenever one or a plurality of components respectively defective or functioning properly are restored by the test means respectively to a condition of satisfactory operation or of failure, this for one or a plurality of combinations of the components of the assembly, considered separately;

— means (CPRE, BL) of stopping the test means.

2. Test system according to Claim 1, characterised in that all the references of the defective components defining a break if the circuit is defective and all the references of the components which are functioning properly defining a link if the circuit is functioning properly, the order of the break or link being defined as being respectively the number of references of the defective or properly functioning components, the test means (MT) comprise memorising means (M) incorporating a flip-flop (31) for memorising the results of simulation, having an input (PR) for operating initialisation so that the said flip-flop (31) shows, upon initialisation, the said first initial and predetermined logic state, corresponding respectively to a minimal break or a minimal connection if the said state is restored at the end of the test, said memorising means comprising furthermore a logic circuit ($ET_8$) of which one input is connected to the output of the circuit (C) to be tested and of which one output operates a change in state of the flip-flop, so as to obtain at the output (35) thereof the said second logic state which is complementary to the said first initial logic state, in the event of the output of the circuit (C) to be tested not changing level when the complementary state of a component is simulated, describing respectively the break or connection which is under consideration, this being applicable to each of the components describing the break or the connection, taken separately, the flip-flop remaining in its initial state if the output of the circuit (C) changes state.

3. System according to Claim 2, characterised in that the test means (MT) comprise furthermore an assembly of at least n flip-flops ($P_1$, $P_2$ ... $P_i$ ... $P_n$) for memorising the logic states of simulation, the outputs ($QP_1$, $QP_1$ ... $QP_i$ ... $QP_n$) in these flip-flops being connected respectively to the simulation inputs (17 or 19 or 21 ...) of the components describing the break or connection, the logic states for simulating a fault or satisfactory operation of the components of the circuit (C) being charged in these flip-flops ($P_1$, $P_1$ ... $P_i$ ... $P_n$) at the initialisation of the system of operating means (MC) of which the operating outputs ($QL_1$, $QL_1$ ... $QL_i$ ... $QL_n$, $M_1$, $M_2$, Q, C, R) are connected to inputs of a logic assembly ($EL_1$, $EL_2$) for selecting and operating flip-flops ($P_i$) so that the output ($QP_i$) of each flip-flop ($P_i$) for memorising a simulation condition, as selected, successively and respectively exhibits the logic state of the flip-flop at initialisation the reverse logic state, then once again the logic state of the flip-flop at initialisation.

4. System according to Claim 3, characterised in that the operating means (MC) comprise an offset register (L) comprising at least n operating flip-flops ($L_1$, $L_2$ ... $L_i$ ... $L_n$) connected in series and each having an operating output ($QL_i$), this register also having a general zeroing input (RAZL), an input for memorising a signal ($QL_0$) showing a predetermined logic state and an offset operating input (CL) for this signal, the operating inputs of the logic selecting assembly ($EL_1$, $EL_2$) being connected to the operating outputs ($QL_1$ ... $QL_i$ ... $QL_n$) of the flip-flops ($L_1$ ... $L_i$ ... $L_n$) of the offset registrer, (L) the outputs of this logic assembly being linked to operating inputs ($PR_1$ ... $PR_i$ ... $PR_n$, $CL_1$ ... $CL_i$ .... $CL_n$) of the flip-flops ($P_i$) of the assembly (P), the logic assembly $EL_1$, $EL_2$) being constituted in such a way that each flip-flop ($P_i$) selected to apply a simulation signal to the simulation input of each predetermined component corresponds to the presence of a predetermined logic level on the operating output ($QL_i$) of the corresponding flip-flop ($L_i$), this logic assembly comprising furthermore two supplementary operating inputs adapted respectively to receive test signals ($MA_0$, $MA_1$) so that the output of each flip-flop ($P_i$) selected successively shows the logic state of the flip-flop at initialisation, the logic state which is the reverse of the initial state, then once again the initial logic state of this flip-flop.

5. System according to Claim 4, characterised in that the operating means (MC) comprise furthermore logic means (SYN) for achieving synchronism to produce at the outputs the operating signals (SYNC) for memorising the results of simulation, of the signals (RAZL, $QL_0$, CL) for zeroing the offset register (L), for memorising and for controlling the offset (L), applied to the corresponding inputs of the first flip-flop of the register (L) and an initialising signal (INIT) applied to the corresponding input of the flip-flop (31) for memorising the simulation results.

6. System according to Claim 5, characterised in that it comprises furthermore a counter (CPRE) which is initially charged to the value of the order of the break or connection, this counter having an input (CP) connected to the output (34) of the synchronising logic means which produces the operating signals (SYNC) for memorising the simulation results, the content of this counter decreasing by one unit at each operating signal for memorising simulation results, an output of this counter being connected to an input (BL) for controlling the stoppage of the synchronising means (SYN) in order to stop the system when all the components have been tested.

7. System according to Claim 6, characterised in that an output (35) of the flip-flop (31) for memorising the simulation results is connected on the one hand to means (36) of indicating that the break or connection is not minimal and on the other to the operating input (BL) for stopping the synchronising means (SYN) in order to stop the system when the break or connection is not minimal.

8. System according to Claim 5, characterised in that the logic selection and operating assembly comprises two AND gate assemblies ($EL_1$, $EL_2$) each comprising a number of gates equal to the number n of flip-flops ($P_i$) and to the number n of flip-flops ($L_i$), each of these gates corresponding to a flip-flop ($L_i$) and a flip-flop ($P_i$), each AND gate (39) of the first assembly ($EL_1$) having an input (38) connected to an output ($QL_1$) for operating the corresponding flip-flop ($L_1$) of the offset register (L) and another input (40) connected to the output ($M_0$) of the synchronising means in order to receive one of the signals ($MA_0$) for operating the test, the output of this flip-flop being connected to one of the inputs ($CL_1$) for operating the flip-flop ($P_1$) of the assembly (P) in order to cause it to pass into the state which is the reverse of its initial state, each AND gate (41) of the second assembly ($EL_2$) having an input (42) connected to an operating output ($QL_1$) of the corresponding flip-flop ($L_1$) of the offset register (L) and another input (43) connected to the output ($M_1$) of the synchronising means (SYN) in order to receive another ($MA_1$) of the test control signals, the output of this AND gate being connected to another of the inputs ($PR_1$) for operating the corresponding flip-flop ($P_1$) of the assembly (P) to restore this flip-flop to its initial condition.

9. System according to Claim 8, characterised in that the logic operating and selecting assembly comprises furthermore a third logic assembly ($EL_3$) of AND gates, each AND gate having an input connected to the operating output ($QL_i$) of the corresponding flip-flop ($L_i$) of the offset register (L) and another input connected to the output of the corresponding flip-flop ($P_i$) of the memorising assembly (P), the outputs of these AND gates being connected to the inputs of an OR gate (48) the output of which is connected to another operating input (49) of synchronising means (SYN) to indicate the presence of a logic state of simulation on an output of a selected flip-flop ($P_i$) in the memorising assembly (P).

10. System according to Claim 8, characterised in that the flip-flop ($P_i$) for memorising simulation logic conditions are grouped by identical assemblies (P, P' ...) on identical modules ($m_1$, $m_2$) connected in series, each of these modules comprising an offset register (L, L' ...) so that the offset registers are linked in series, the output of the last flip-flop for memorising logic simulation conditions in one module ($m_1$) being connected to the loading input of the first flip-flop of the following module ($m_2$), the first flip-flop ($L_1$) of the first offset register having inputs for memory, zeroing and offset control ($QL_0$, RAZL, CL), while the operating output of the last flip-flop of an offset register is connected to the memorising input of the following offset register, the logic operating and selecting assembly comprising furthermore, for each module, a third assembly of AND gates ($EL_3$, $E'L_3$), each AND gate having an input connected to the operating output of the corresponding flip-flop ($L_i$) of the offset register of this module, and another input connected to the output of the corresponding flip-flop ($P_i$) of the corresponding assembly (P), the outputs of these AND gates for each module being connected to the inputs of an OR gate (48, 51) the output of which is connected to another operating input (49) via synchronising means (SYN), through a transistor mounted as an open collector to indicate the presence of a logic simulation condition on an output of a flip-flop ($P_i$) selected in a memorising assembly (P or P') of one of the modules ($m_1$, $m_2$).

**Ansprüche**

1. System zum Testen des Versagens oder Funktionierens einer Schaltung (C) mit logischen Schaltkreisen, in der n Schaltkreise eine Gesamtheit von Schaltkreisen bilden, die in vorbestimmter Weiser von 1 bis n markiert und untereinander so verbunden sind, daß diese Gesamtheit an einem Ausgang einen logischen Zustand aufweist, welcher den Zustand des Versagens oder dem Funktionieren der Gesamtheit entspricht und von dem Zustand des Versagens oder Funktionierens von jedem der n Schaltkreise der Gesamtheit abhängt, wobei jeder der n Schaltkreise der Gesamtheit wenigstens einen Simulationseingang aufweist, der ein Simulationssignal für das Versagen oder Funktionieren dieses Schaltkreises empfangen kann, dadurch gekennzeichnet, daß das System umfaßt :

— Mittel zum Testen (MT), deren Ausgänge entsprechend mit den Simulationseingängen der Schaltkreise verbunden sind, wobei diese Mittel zum Testen einen oder mehrere Schaltkreise in einen Zustand des Versagens oder des Funktionierens bringen können, dann umgekehrt und wechselseitig diesen oder diese Schaltkreise in einen Zustand des Funktionierens oder des Versagens bezüglich einer oder mehrerer Kombinationen unter den n Schaltkreisen der Gesamtheit zurückbringen, und wobei diese Mittel zum Testen einen charakteristischen Ausgang (35) aufweisen, welcher, wenn der Ausgang der Gesamtheit einen Zustand des Versagens oder des Funktionierens aufweist, der einen Zustand des Versagens oder des Funktionierens der Schaltkreise der Gesamtheit entspricht, ein Signal bereitstellt, welches darstellt :

— einen ersten logischen Zustand, wenn der Ausgang der Gesamtheit einen Zustand des Funktionierens oder einen Zustand des Versagens jedesmal dann aufweist, wenn ein oder mehrere versagende bzw. funktionierende Schaltkreise durch die Mittel zum Testen zum Funktionieren oder Versagen zurückgebracht sind und zwar bei einer oder mehreren Kombinationen der Schaltkreise der Gesamtheit, die getrennt genommen sind,

— einen zweiten logischen Zustand, wenn der Ausgang der Gesamtheit einen Zustand des Versagens oder des Funktionierens jedesmal dann aufweist, wenn ein oder mehrere versagende bzw. funktionierende Schaltkreise durch die Testmittel in einen Zustand des Funktionierens bzw. des Versagens zurückgebracht sind und zwar für eine oder mehrere Kombinationen der Schaltkreise der Gesamtheit, die getrennt genommen sind,

— Mittel (CPRE, BL) zum Anhalten der Mittel zum Testen.

2. System zum Testen nach Anspruch 1, dadurch gekennzeichnet, daß die Gesamtheit der Markierungen der versagenden Schaltkreise einen Schnitt definiert, wenn der Schaltkreis versagt, und die Gesamtheit der Markierungen der funktionierenden Schaltkreise eine Verbindung definiert, wenn der Schaltkreis funktioniert, wobei die Ordnung des Schnittes oder der Verbindung als die Anzahl der Markierungen der versagenden bzw. funktionierenden Schaltkreise definiert ist, daß die Mittel zum Testen (MT) Mittel zum Speichern (M) mit einer Speicherkippschaltung (31) zum Speichern der Simulationsergebnisse aufweisen, welche einen Steuereingang (PR) zur Initialisierung besitzt, der ein Steuersignal zur Initialisierung empfangen kann, damit diese Kippschaltung (31) bei der Initialisierung den ersten, vorbestimmten, logischen Anfangszustand aufweist, der einem minimalen Schnitt bzw. einer minimalen Verbindung entspricht, wenn dieser Zustand am Testende wieder hergestellt ist, daß die Mittel zum Speichern ferner eine logischen Schaltkreis ($ET_8$) umfassen, dessen einer Eingang mit dem Ausgang des zu testenden Schaltkreises (C) verbunden ist und bei dem ein Ausgang die Zustandsänderung der Kippschaltung steuert derart, daß an ihrem Ausgang (35) der zweite, zu dem ersten, logischen Anfangszustand komplementäre logische Zustand in dem Fall erhalten wird, bei dem der Ausgang des zu testenden Schaltkreises (C) keine Pegeländerung aufweist, wenn der komplementäre Zustand eines Schaltkreises simuliert wird, der den untersuchten Schnitt oder die untersuchte Verbindung beschreibt und zwar für jeden der den Schnitt oder die Verbindung beschreibenden Schaltkreise, die für sich getrennt genommen werden, und daß die Kippschaltung in ihrem Ausgangszustand in dem Fall bleibt, bei dem der Ausgang des Schaltkreises (C) den Zustand ändert.

3. System nach Anspruch 2, dadurch gekennzeichnet, daß die Mittel zum Testen (MT) ferner umfassen eine Gesamtheit von wenigstens n Kippschaltungen ($P_1$, $P_2$ ... $P_i$ ... $P_n$) zum Speichern der logischen Simulationszustände, wobei deren Ausgänge ($QP_1$, $QP_2$ ... $QP_i$ ... $QP_n$) mit den entsprechenden Simulationseingängen (17 oder 19 oder 21 ...) der den Schnitt oder die Verbindung beschreibenden Schaltkreise verbunden sind und die logischen Simulationszustände des Versagens oder des Funktionierens der Schaltkreise des Schaltkreises (C) bei der Initialisierung des Systems in die Kippschaltungen ($P_1$, $P_2$ ... $P_i$ ... $P_n$) geladen werden,

sowie Mittel zum Steuern (MC), deren Steuerausgänge ($QL_1$, $QL_2$ ... $QL_i$ ... $QL_n$, $M_1$, $M_2$, Q, C, R) mit Eingängen einer logischen Gesamtheit ($EL_1$, $EL_2$) zum Auswählen und Steuern der Kippschaltungen ($P_i$) verbunden sind, damit der Ausgang ($QP_i$) einer jeden ausgewählten Speicherkippschaltung ($P_i$) für den Simulationszustand aufeinanderfolgend den logischen Zustand der Kippschaltung bei der Initialisierung, den umgekehrten, logischen Zustand und dann erneut den logischen Zustand der Kippschaltung bei der Initialisierung aufweist.

4. System nach Anspruch 3, dadurch gekennzeichnet, daß die Mittel zum Steuern (MC) umfassen ein Schieberegister (L) mit wenigstens n Steuerkippschaltungen ($L_1$, $L_2$ ... $L_i$ ... $L_n$), die in Reihe verbunden sind und jeweils einen Steuerausgang ($QL_i$) aufweisen, wobei das Register ferner einen allgemeinen Eingang (RAZL) zum Zurücksetzen auf Null, einen Eingang zum Speichern eines Signals ($QL_0$), welches einen vorbestimmten, logischen Zustand darstellt, und einen Steuereingang (CL) zum Verschieben dieses Signals aufweist, daß die Steuereingänge der logischen Gesamtheit zum Auswählen ($EL_1$, $EL_2$) mit dem Steuerausgängen ($QL_1$ ... $QL_i$ ... $QL_n$) der Kippschaltungen ($L_1$ ... $L_i$ ... $L_n$) des Schieberegisters (L) verbunden sind, daß die Ausgänge dieser logischen Gesamtheit mit den Steuereingängen ($PR_1$ ... $PR_i$ ... $PR_n$, $CL_1$ ... $CL_i$ ... $CL_n$) der Kippschaltungen ($P_i$) der Gesamtheit (P), verbunden sind, daß die logische Gesamtheit ($EL_1$, $EL_n$) derart ausgebildet ist, daß jede Kippschaltung ($P_i$) die ausgewählt ist, um ein Simulationssignal an den Simulationseingang jedes vorbestimmten Schaltkreises zu legen, dem Vorhandensein eines vorbestimmten, logischen Pegels an dem Steuerausgang ($QL_i$) der entsprechenden Kippschaltung ($L_i$) entspricht, daß diese logische Gesamtheit ferner zwei zusätzliche Steuereingänge aufweist, die Steuersignale ($MA_0$, $MA_1$) für den Test empfangen können, damit der Ausgang einer jeden augewählten Kippschaltung ($P_i$) aufeinanderfolgend den logischen Zustand der Kippschaltung bei der Initialisierung, den zu dem Anfangszustand umgekehrten logischen Zustand und dann erneut den logischen Anfangszustand dieser Kippschaltung aufweist.

5. System nach Anspruch 4, dadurch gekennzeichnet, daß die Mittel zum Steuern (MC) ferner logische Mittel (SYN) zur Synchronisation aufweisen, um an Ausgängen die Signale (SYNC) zum Steuern des Speicherns der Simulationsergebnisse, Signale (RAZL, $QL_0$, CL) zum Zurücksetzen auf Null des Schieberegisters (L), zum Speichern und zum Steuern der Verschiebung (L), die an die entsprechenden Eingänge der ersten Kippschaltung des Registers (L) angelegt werden, und ein Signal (INIT) zum Steuern der Initialisierung zu erzeugen, welches an den entsprechenden Eingang der Speicherkippschaltung (31) für die Simulationsergebnisse gelegt wird.

6. System nach Anspruch 5, dadurch gekennzeichnet, daß es ferner einen Zähler (CPRE) aufweist, welcher anfangs mit dem Wert der Ordnung des Schnittes oder der Verbindung geladen wird und einen Eingang (CP) aufweist, welcher mit dem Ausgang (34) der logischen Mittel zum Synchronisieren verbunden ist, der die Steuersignale (SYNC) zur Speicherung der Simulationsergebnisse erzeugt, daß der Inhalt dieses Zählers bei jedem Steuersignal zur Speicherung der Simulationsergebnisse um eine Einheit abnimmt, daß ein Ausgang dieses Zählers mit einem Steuereingang (BL) zum Anhalten der Mittel zur Synchronisierung (SYN) verbunden ist, um das System anzuhalten, wenn alle Schaltkreise geprüft worden sind.

7. System nach Anspruch 6, dadurch gekennzeichnet, daß ein Ausgang (35) der Kippschaltung zum Speichern (31) der Simulationsergebnisse einerseits mit Mitteln (36), um anzuzeigen, daß der Schnitt oder die Verbindung nicht minimal ist, und andererseits mit dem Steuereingang (BL) zum Anhalten der Mittel zum Synchronisieren (SYN) verbunden ist, um das System anzuhalten, wenn der Schnitt oder die Verbindung nicht minimal ist.

8. System nach Anspruch 5, dadurch gekennzeichnet, daß die logische Gesamtheit zum Auswählen und Steuern zwei Gesamtheiten ($EL_1$, $EL_2$) von Toren ET aufweist, von denen jede eine Anzahlen von Toren umfaßt, die gleich der Anzahl n von Kippschaltungen ($P_i$) und der Anzahl n von Kippschaltungen ($L_i$) ist, daß jedes dieser Tore einer Kippschaltung ($L_i$) und einer Kippschaltung ($P_i$) entspricht, daß jedes Tor ET (39) der ersten Gesamtheit ($EL_1$) einen Eingang (38), der mit einem Steuerausgang ($QL_1$) der dem Schieberegister (L) entsprechenden Kippschaltung ($L_1$) verbunden ist, und einen weiteren Eingang (40) aufweist, der mit dem Ausgang ($M_0$) der Mittel zum Synchronisieren verbunden ist, um eines der Steuersignale ($MA_0$) für den Test zu empfangen, daß der Ausgang dieser Kippschaltung mit einem der Steuereingänge ($CL_1$) der Kippschaltung ($P_1$) der Gesamtheit (P) verbunden ist, um diesen in dem gegenüber seinem Anfangszustand umgekehrten Zustand hindurchzulassen, daß jedes Tor ET (41) der zweiten Gesamtheit ($EL_2$) einen Eingang (42), der mit einem Steuerausgang ($QL_1$) der dem Schieberegister (L) entsprechenden Kippschaltung ($L_1$) verbunden ist, und einem weiteren Eingang (43) aufweist, der mit dem Ausgang ($M_1$) der Mittel zum Synchronisieren (SYN) verbunden ist, um ein anderes ($MA_1$) der Steuersignale zum Testen zu empfangen, daß der Ausgang dieses Torr ET mit einem anderen der Steuereingänge ($PR_1$) der Kippschaltung ($P_1$) verbunden ist, die der Gesamtheit (P) entspricht, um diese Kippschaltung in den Anfangszustand zurückzubringen.

9. System nach Anspruch 8, dadurch gekennzeichnet, daß die logische Gesamtheit zum Steuern und Auswählen ferner eine dritte logische Gesamtheit ($EL_3$) von Toren ET umfaßt, daß jedes Tor ET einen Eingang, der mit dem Steuerausgang ($QL_i$) der entsprechenden Kipp-

schaltung ($L_i$) des Schieberegisters (L) verbunden ist, und einen weiteren Eingang aufweist, der mit dem Ausgang der der Gesamtheit zum Speichern (P) entsprechenden Kippschaltung ($P_i$) verbunden ist, daß die Ausgänge dieser Tore ET mit den Eingängen eines ODER-Tores (48) verbunden sind, dessen Ausgang mit einem weiteren Steuereingang (49) der Mittel zum Synchronisieren (SYN) verbunden ist, um das Vorliegen eines logischen Simulationszustandes an einem Ausgang einer aus der Gesamtheit zum Speichern (P) ausgewählten Kippschaltung ($P_i$) anzuzeigen.

10. System nach Anspruch 8, dadurch gekennzeichnet, daß die Kippschaltungen ($P_1$) zum Speichern der logischen Simulationszustände in identischen Gesamtheiten (P, P' ...) auf in Reihe verbundenen, identischen Modulen ($m_1$, $m_2$) gruppiert sind, daß jedes dieser Module ein Schieberegister (L, L' ...) aufweist derart, daß die Schieberegister in Reihe verbunden sind, wobei der Ausgang der letzten Kippschaltung zum Speichern der logischen Simulationszustände eines Moduls ($m_1$) mit dem Eingang zum Laden der ersten Kippschaltung des folgendes Moduls ($m_2$) verbunden ist, daß die erste Kippschaltung ($L_1$) des ersten Schieberegisters Eingänge zum Speichern, zum Zurücksetzen auf Null und zum Steuern der Verschiebung ($QL_0$, RAZL, CL) aufweist, während der Steuerausgang der letzten Kippschaltung eines Schieberegisters mit dem Eingang zum Speichern des folgenden Schieberegisters verbunden ist, daß die logische Gesamtheit zum Steuern und Auswählen ferner für jeden Modul eine dritte Gesamtheit von Toren ET ($EL_3$, $E'L_3$) umfaßt, wobei jedes Tor ET einen Eingang, der mit dem Steuerausgang der dem Schieberegister dieses Moduls entsprechenden Kippschaltung ($L_i$) verbunden ist, und einen anderen Eingang aufweist, der mit dem Ausgang der Kippschaltung ($P_i$) verbunden ist, welche der entsprechenden Gesamtheit (P) entspricht, daß die Ausgänge dieser Tore ET bei jedem Modul mit den Eingängen eines ODER-Tores (48, 51) verbunden sind, deren Ausgang mit einem anderen Steuereingang (49) der Mittel zum Synchronisieren (SYN) über einen mit offenem Kollektor geschalteten Transistor verbunden ist, um das Vorliegen eines logischen Simulationszustandes an einem Ausgang einer Kippschaltung ($P_i$) anzuzeigen, welche aus einer Gesamtheit zum Speichern (P oder P') einer der Module ($m_1$, $m_2$) ausgewählt ist.

7
6
8
5
4
1
3
2

FIG. 1A

14
13
15
11
10
9
5
12
4
1
3
16
2
0= défaillance

FIG. 1B

30
ET1
OU1
20
22
ET3
17
18
0= défaillance
21
ET2
19

FIG. 2A

23
ET4
24
25
OU2
27
29
ET6
ET5
1 = bon fonctionnement
28
26

FIG. 2B

FIG. 3
30
1
QP1
QP2
QP3
QPn
QPi
17
19
21
22
0
ET1
ET2
ET3
ET8
OU1
C
M
MT
MC
31
32
33
34
35
36
37
PR
CLEAR
CP
CPRE
SYNC
INIT
SYN
BL
M1
M0
Q C R
43
41
42
MA0
MA1
EL2
EL1
P
PR1
CL1
P1
PR2
CL2
P2
P3
Pi
PRn
CLn
Pn
40
39
38
QL0
QL1
QL2
QL3
QLi
QLn
CL
L1
L2
Li
Ln
L
RAZ L

FIG. 4
$MA_1$
$m_1$
$m_2$
$EL_1$
$EL_2$
$EL_3$
$E'L_1$
$E'L_2$
$E'L_3$
P
P'
$P_1$
$P_2$
$P_i$
$P_n$
$QP_1$
$QP_2$
$QP_i$
$QP_n$
$Q'P_1$
$Q'P_2$
$Q'P_i$
$Q'P_n$
$QL_0$
$QL_1$
$QL_2$
$QL_i$
$QL_n$
$Q'L_0$
$Q'L_1$
$Q'L_2$
$Q'L_i$
$Q'L_n$
$L_1$
$L_2$
$L_i$
$L_n$
L
$MA_0$
$MA_1$
CL
RAZ L
E
C
M
SYNC
INIT
CPRE
BL
Q
R
SYN
BUS
LECT
36
37
45
46
47
48
49
50
51
52

C
22
M
35
A
P
P1
P2
P3
MA0
SYN
MA1
L
1
0
0
CL

FIG. 5